(19) Europäisches Patentamt
European Patent Office
Office européen des brevets

(11) **EP 2 577 818 B1**

## (12) EUROPÄISCHE PATENTSCHRIFT

(45) Veröffentlichungstag und Bekanntmachung des Hinweises auf die Patenterteilung:
**15.07.2020 Patentblatt 2020/29**

(21) Anmeldenummer: **11720794.4**

(22) Anmeldetag: **24.05.2011**

(51) Int Cl.:
*H01S 3/06* $^{(2006.01)}$    *H01S 3/113* $^{(2006.01)}$
*H01S 5/183* $^{(2006.01)}$    *H01S 5/04* $^{(2006.01)}$
*H01S 3/094* $^{(2006.01)}$    *H01S 3/102* $^{(2006.01)}$
*H01S 3/16* $^{(2006.01)}$    *H01S 5/065* $^{(2006.01)}$
*H01S 5/20* $^{(2006.01)}$

(86) Internationale Anmeldenummer:
**PCT/EP2011/058401**

(87) Internationale Veröffentlichungsnummer:
**WO 2011/147799 (01.12.2011 Gazette 2011/48)**

### (54) ULTRAKURZPULS-MIKROCHIPLASER, HALBLEITERLASER, LASERSYSTEM UND PUMPVERFAHREN FÜR DÜNNE LASERMEDIEN

ULTRASHORT PULSE MICROCHIP LASER, SEMICONDUCTOR LASER, LASER SYSTEM, AND PUMP METHOD FOR THIN LASER MEDIA

LASER MICRO-PUCE À IMPULSIONS ULTRA-COURTES, LASER SEMI-CONDUCTEUR, SYSTÈME LASER ET PROCÉDÉ DE POMPAGE POUR MILIEUX LASER MINCES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.05.2010 EP 10164247**

(43) Veröffentlichungstag der Anmeldung:
**10.04.2013 Patentblatt 2013/15**

(73) Patentinhaber: **Kopf, Daniel**
**6832 Röthis (AT)**

(72) Erfinder: **Kopf, Daniel**
**6832 Röthis (AT)**

(74) Vertreter: **Kaminski Harmann**
**Patentanwälte AG**
**Landstrasse 124**
**9490 Vaduz (LI)**

(56) Entgegenhaltungen:
DE-A1- 10 260 183    US-A- 5 343 485
US-A- 5 495 494    US-A1- 2004 233 961
US-A1- 2005 094 689    US-A1- 2006 193 358
US-A1- 2007 189 350

- **NODOP D ET AL: "HIGH-PULSE-ENERGY PASSIVELY Q-SWITCHED QUASI-MONOLITHIC MICROCHIP LASERS OPERATING IN THE SUB-100-PS PULSE REGIME", OPTICS LETTERS, OSA, OPTICAL SOCIETY OF AMERICA, WASHINGTON, DC, US LNKD-DOI:10.1364/OL.32.002115, Bd. 32, Nr. 15, 1. August 2007 (2007-08-01), Seiten 2115-2117, XP001506842, ISSN: 0146-9592**
- **PALLMANN W P ET AL: "Novel ultrafast vertically emitting semiconductor lasers", OPTICAL COMMUNICATION (ECOC), 2010 36TH EUROPEAN CONFERENCE AND EXHIBITION ON, IEEE, PISCATAWAY, NJ, USA, 19. September 2010 (2010-09-19), Seiten 1-3, XP031789686, ISBN: 978-1-4244-8536-9**

**Beschreibung**

Die Erfindung betrifft einen Ultrakurzpuls-Mikrochiplaser zur Erzeugung von Femto- oder Pikosekundenpulsen nach Anspruch 1 und ein Pumpverfahren desselben nach Anspruch 12. Ultrakurzpulslasersysteme, das heißt Laseranordnungen, die in der Lage sind, Laserpulse mit einer charakteristischen Pulsdauer im Femto- oder Pikosekundenbereich zu erzeugen, sind seit langem in verschiedenen Ausführungsformen aus dem Stand der Technik bekannt. Neben komplexen Anordnungen mit langen Resonatoren kommen hierbei auch Mikrochiplaser zum Einsatz.

So sind gütegeschaltete Mikrochiplaser, die eine Pulslänge von einigen 10 Pikosekunden im nahen Infrarot emittieren, in ihrem grundsätzlichen Aufbau bereits aus Spühler G.J. et al. "Experimentally confirmed design guidelines for passively Q switched microchip lasers using semiconductor saturable absorbers", JOSA B, Vol. 16, Nr. 3, März 1999 bekannt. Diese Laser haben den Vorteil der besonderen Kompaktheit gegenüber modengekoppelten Lasern, da der Laserresonator selber ein Volumen von nur wenigen Kubikmillimetern oder sogar weniger einnimmt, wohingegen auch sehr kompakte modengekoppelte Resonatoren aufgrund der erforderlichen Resonatorlänge etliche Zentimeter Kantenlänge aufweisen. Darüber hinaus besteht der Vorteil, dass Laserpulse bei geringerer Pulswiederholrate und dafür höherer Pulsenergie erzeugt werden als bei handelsüblichen, modengekoppelten Oszillatoren mit geringer Leistung.

In Braun B. et al. "56-ps passively Q-switched diode-pumped microchip laser", Optics Letters, Vol. 22, Nr. 6, März 1997 ist beispielsweise eine Anordnung publiziert, die aus einem 200 $\mu$m dünnen Lasermedium aus Nd:Vanadat besteht, das auf der einen Seite mit einem Laserspiegel und auf der anderen Seite mit einem sättigbaren Absorberspiegel bzw. SESAM (Semiconductor Saturable Absorber Mirror) abgegrenzt ist. Die publizierte Pulsenergie beträgt einige 10 nJ. Das Lasermedium wird hierbei als einzelnes Stück gefertigt und dann zwischen die beiden Endelemente Auskoppler und SESAM positioniert, ohne dass ein Bonding vorgenommen wird.

Aus Zayhowski J.J. und Wilson A.L. "Short-pulsed Nd:YAG/Cr4+:YAG passively Q-switched microchip lasers", OSA/CLEO 2003 ist bekannt, dass mit einer SandwichAnordnung aus Nd:YAG und passiver Güteschaltung aus $Cr^{4+}$:YAG Pulslängen um 150 ps erreicht werden können. Diese Anordnung erreicht bei hohem Kompaktheitsgrad Pulsenergien bis in den $\mu$J-Bereich hinein, jedoch bei Pulslängen, die über 100 ps liegen, da die passive Güteschaltung bzw. das Material $Cr^{4+}$:YAG eine gewisse Länge erforderlich machen, so dass keine Optimierung hin zu kürzeren Pulslängen ermöglicht wird. Somit sind diese Laser für Anwendungen nicht geeignet, in denen die Bereitstellung ultrakurzer Pulse erforderlich ist.

In Nodop D. et al. "High-pulse-energy passively Q-switchedquasi-monolithic microchip lasers operating in the sub-100-ps pulse regime", Optics Letters, Vol. 32, Nr. 15, August 2007, wird eine ebenfalls auf SESAM-Technologie beruhende Anordnung vorgestellt, bei der ein 200 $\mu$m dicker Laserkristall mit einer Spin-on-glass-Klebetechnik auf die thermisch gut leitenden SESAM-Komponente aufgebracht wird. Auf dem Kristall ist sodann wiederum ein dichroitischer Auskoppler durch Beschichtung angebracht, der das Pumplicht passieren lässt und das Laserlicht teilweise auskoppelt. Diese Anordnung ist für die zur Erreichung noch kürzerer Pulse noch dünner ausgelegte Kristalle nicht geeignet. Des Weiteren sind Mikrochiplaser auch aus der US 5 343 485A und der US 2005/0 094 689 A1 bekannt Damit sind aus dem Stand der Technik zwar Pikosekunden-Mikrochiplaser bekannt, die jedoch minimal nur eine Pulslänge von einigen 10 Pikosekunden erreichen können, wobei die minimale publizierte Pulslänge 37 ps beträgt. Selbst solche kurzen Pulslängen sind jedoch für einige Anwendungen noch zu lang.

Um kürzere Pulsdauern erzeugen zu können, müsste das Lasermedium noch dünner ausgelegt werden, was jedoch fertigungstechnisch problematisch ist, da die Herstellung und Handhabung von Lasermedien als Komponenten mit einer Dicke von 100 $\mu$m oder darunter Schwierigkeiten bereitet. Darüber hinaus ergibt sich das Problem der verschiedenen thermischen Ausdehnungskoeffizienten, die in einem solchen Miniaturresonator aufgrund der Verwendung verschiedener Materialien zwangsläufig vorhanden sind und zu thermisch induziertem Bruch im Material oder zur Ablösung an einer Grenzschicht führen können. Des weiteren ist die erreichbare thermische Linse, die für eine geeignete Modenbildung notwendig ist, aufgrund des longitudinal immer stärker werdenden Wärmeprofils und -abflusses nicht mehr ausreichend. Ein weiteres Problem stellt die Tatsache dar, dass die Energiedichten in einem SESAM zu hoch werden und optische Zerstörung resultieren können, so dass ein entsprechender Dauerbetrieb daher in Lösungen des Stands der Technik nicht möglich ist. Zudem ergibt sich bei immer dünner werdendem Lasermedium das Problem, dass auch die Verstärkung geringer wird. Schliesslich ergibt sich ein weiteres Problem dadurch, dass bei sehr dünnen Lasermedien die Schwingungsbäuche der Pumpstrahlung - wenn diese an der einer Eintrittsfläche gegenüberliegenden Fläche oder Grenzschicht in sich zurückreflektiert wird - aufgrund der verschiedenen Wellenlängen von den Schwingungsbäuchen der Laserstrahlung abweicht bzw. hierdurch kein optimaler Überlapp gewährleistet ist oder aber der Überlapp auseinanderläuft.

Eine Aufgabe der vorliegenden Erfindung besteht in der Verbesserung von Ultrakurzpuls-Mikrochiplasern in Hinblick auf die zeitliche Charakteristik der erzeugten Laseremission. Eineweitere Aufgabe besteht in der Bereitstellung von Mikrochiplasern zur Erzeugung von Femto- oder Pikosekundenpulsen mit Pulsdauern unter 30 ps, insbesondere unter 1 ps.

Eine weitere Aufgabe besteht in der Bereitstellung eines Pumpverfahrens für sehr dünne Lasermedien.

Die Aufgabe der vorliegenden Erfindung wird gelöst durch einen Laser und ein Pumpverfahren desselben nach Anspruch 1,12. Bevorzugte Ausführungsformen sind in den abhängigen Ansprüchen definiert.

Die Erfindung betrifft die Erzeugung von ultrakurzen Laserpulsen durch Mikrochiplaser, die ein optisch gepumptes Lasermedium aufweisen. Dieses Lasermedium befindet sich hierbei in einem gattungsgemäss sehr kurzen Laserresonator, der durch reflektierende Grenzflächen des Lasermediums oder durch entsprechende separate Komponenten definiert wird. Dabei können diese Elemente direkt und ohne Zwischenräume miteinander verbunden sein oder aber eine gewisse Beabstandung aufweisen. Zur Verbindung separater Elemente oder zu deren Ausformung als funktionale Komponente auf einem Trägermaterial stehen im Stand der Technik verschiedene Verfahren zur Verfügung, wie z.B. Diffusionsbonding, Ionenstrahlsputtering oder optische Klebeverbindungen.

Erfindungsgemäss wird ein zur Erzeugung von Laserpulsen mit einer zeitlichen Charakteristik von unter 30 ps, insbesondere unter 10 oder unter 1 ps, benötigtes Lasermedium bzw. ein entsprechender Resonator nicht durch Zusammenfügen separater Komponenten gebildet, sondern es werden ein Substrat und das Lasermedium miteinander verbunden, wobei das Lasermedium eine vergleichsweise grosse Materialstärke von bspw. über 200 $\mu$m aufweisen kann. Nach der Verbindung dieser Elemente, zwischen denen auch weitere Schichten angeordnet sein können, erfolgt eine Reduzierung der ursprünglichen Materialstärke des Lasermediums, z.B. durch Abschleifen oder Abpolieren, bis hin zur für die kurzen Pulsdauern erforderliche Dicke.

Um thermische Effekte und Spannungen zu vermeiden, werden Substrat und Lasermedium bevorzugt aus dem gleichen Material gefertigt, wobei die Eigenschaften durch gezielte Wahl der Dotierung angepasst werden können.

Aufgrund des sehr dünnen Lasermediums und damit auch des sehr kurzen Laserresonators ist zur Erzielung befriedigender Leistungsparameter eine Anpassung des Pumpverfahrens erforderlich. Hierbei erfolgt erfindungsgemäss die Einkopplung des Pumplichtes unter einem von der Wellenlänge der Pumpstrahlung abhängigen Winkel zur Emissionsrichtung der Laserstrahlung bzw. der Ausdehnung des Lasermediums, so dass die Verstärkung durch örtliche Anpassung der Intensitätsmuster von Laseremission und Pumpstrahlung optimiert werden. Wellenlänge und Einfallswinkel der Pumpstrahlung werden hierbei so gewählt, dass die Pumpstrahlungsisophoten, d.h. die Linien oder Punkte gleicher Helligkeit, einem Intensitätsmuster der Laseremission entsprechen.

Hierzu erfolgt vorteilhafterweise eine Anpassung der Spiegelcharakteristiken, so dass ein Teil des eingekoppelten Pumplichtes im Resonator reflektiert wird. Eine weitere Fortbildung besteht in der Integration von Spiegelfunktionalität und Lasermedium in einer Schichtstruktur, so dass eine Verteilung des Lasermediums entsprechend dem Intensitätsmuster möglich ist. Somit erfolgt eine Anpassung und Abstimmung von Pumpstrahlungs- und Emissionscharakteristik mit der örtlichen Verteilung des Lasermediums. Dieses wird in diesem speziellen Ausführungsbeispiel nicht mehr gesamthaft als isolierter Block plaziert sondern über die gesamte Schichtstruktur verteilt angeordnet.

Die Reflektion des Pumplichts erlaubt die Verwertung des Restlichtes, das ansonsten nicht zur Verfügung stehen würde. Zudem wird im Fall der Verwendung eines sättigbaren Absorbers vermieden, dass durch das Pumplicht gesättigt wird.

Der erfindungsgemässe Ultrakurzpuls-Mikrochiplaser sowie das erfindungsgemässe Pumpverfahren für Lasermedien mit einer Dicke von weniger als 200 $\mu$m werden nachfolgend anhand von in der Zeichnung schematisch dargestellten Ausführungsbeispielen rein beispielhaft näher beschrieben oder erläutert. Im einzelnen zeigen

Fig.1 die schematische Darstellung eines ersten Ausführungsbeispiels des erfindungsgemässen Ultrakurzpuls-Mikrochiplasers;

Fig.2 die schematische Darstellung eines zweiten Ausführungsbeispiels des erfindungsgemässen Ultrakurzpuls-Mikrochiplasers;

Fig.3 die schematische Darstellung der Anordnung eines dritten Ausführungsbeispiels in einem erfindungsgemässen Lasersystems;

Fig.4 die schematische Darstellung des Grundprinzips des erfindungsgemässen Pumpverfahrens;

Fig.5 die Darstellung eines berechneten Beispiels eines Pumpintensitätsmusters für das erfindungsgemässen Pumpverfahrens;

Fig.6 die Veranschaulichung des erfindungsgemässen Pumpverfahrens für ein Lasermedium zwischen zwei reflektierenden Flächen;

Fig.7 die schematische Darstellung eines vierten Ausführungsbeispiels des erfindungsgemässen Ultrakurzpuls-Mikrochiplasers;

Fig.8 die schematische Darstellung eines fünften Ausführungsbeispiels des erfindungsgemässen Ultrakurzpuls-Mikrochiplasers;

Fig.9 die schematische Darstellung eines sechsten Ausführungsbeispiels des erfindungsgemässen Ultrakurzpuls-Mikrochiplasers;

Fig.10 die tabellierte Darstellung der Schichtfolge für das fünfte und sechste Ausführungsbeispiel des erfindungsgemässen Ultrakurzpulslasersystems;

Fig. 11 die schematische Darstellung eines siebten Ausführungsbeispiels des erfindungsgemässen Ultrakurzpulslasersystems;

Fig.12 die Darstellung des Verlaufs der Strahlungsfelder von Pump- und Laserstrahlung;

Fig. 13 die schematische Darstellung eines siebten Ausführungsbeispiels der erfindungsgemässen optimierten Pumpanordnung für dünne Lasermedien und

Fig.14a-e die schematischen Darstellungen von Ausführungsbeispielen erfindungsgemässer vertikal emittierender Halbleiterlaser.

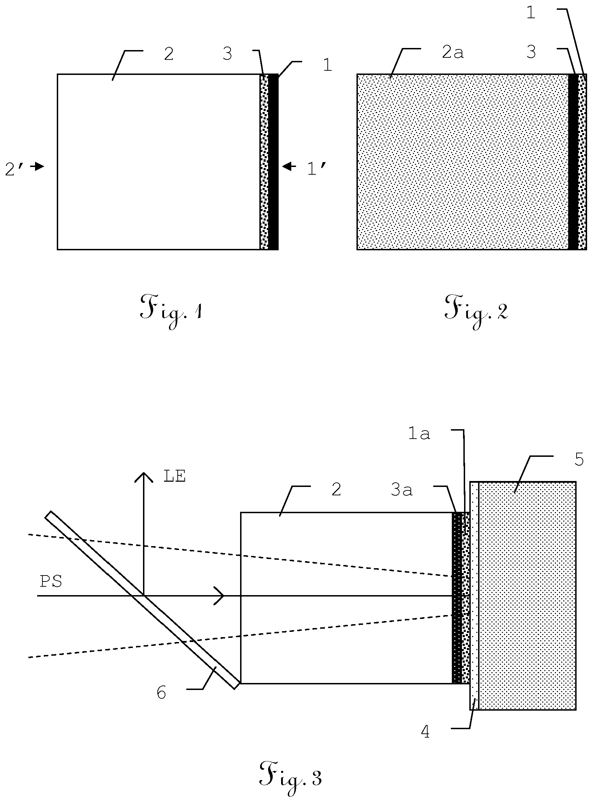

Die in den Abbildungen 1,2,11 und 14a-e gezeigten und auf den Seiten 9-13, 24,25 und 27-33 der Beschreibung diskutierten Anordnungen stellen nur Beispiele zum besseren Verständnis der Erfindung dar obwohl sie als "Ausführungsbeispiel" bezeichnet werden weil sie nicht unter den beanspruchten Gegenstand fallen. Fig.1 zeigt die schematische Darstellung eines ersten Ausführungsbeispiels des erfindungsgemässen Ultrakurzpuls-Mikrochiplasers. Zur Herstellung eines solchen optisch gepumpten Ultrakurzpuls-Mikrochiplasers wird das Lasermedium 1 auf einem Substrat 2 aufgebracht, wobei dieses beispielsweise aus Vanadat bestehen kann und in diesem ersten Ausführungsbeispiel undotiert ist. Vor der Verbindung dieser beiden Elemente wird auf das Substrat 2 eine dichroitische Auskopplerschicht bzw. ein dichroitischer Auskoppelspiegel als erster Resonatorspiegel 3 aufgebracht, wofür verschiedene Verfahren, wie z.B. Ionenstrahlsputtering, zur Verfügung stehen. Für Nd:Vanadat als Lasermedium 1 wird der dichroitischer Spiegel 3 in diesem Beispiel mit einer Reflektivität von 95 % für die Wellenlänge von 1064 nm der zu erzeugenden Laseremission und einem Transmissionsgrad von über 95 % für eine Pumpwellenlänge von 808 nm, wobei als Pumpquellen Laserdioden verwendet werden. Dieser erste Resonatorspiegel 3 ist somit ein zwischen Substrat 2 und Lasermedium 1 angeordneter dichroitischer Auskoppelspiegel, welcher für die Laseremission und für die Pumpstrahlung zumindest teilweise durchlässig oder teilweise reflektierend ausgelegt ist.

Auf das Substrat 2 und den dichroitischen Spiegel 3 wird ein dickes, d.h. noch nicht in seiner Materialstärke reduziertes, poliertes Nd:Vanadat-Stück als Lasermedium 1, beispielsweise mit einer Dotierung von mehr als 1 % Nd, insbesondere auch 3% Nd, aufgebracht. Die ursprüngliche Materialstärke dieser Komponente kann dabei so gewählt werden, dass eine mechanische Handhabung und Verbindung mit dem Substrat 2 bzw. dem dichroitischen Auskoppelspiegel 3 problemlos möglich ist, wobei als Verbindungsverfahren z.B. optischer Kontaktierung oder Diffusionsbonding in Frage kommen. Nach dem Aufbringen wird das Lasermedium 1 in seiner ursprünglichen Materialstärke reduziert, beispielsweise abgeschliffen und/oder abpoliert, bis das verbleibende Stück Nd:Vanadat die gewünschte Dicke von weniger als 200 $\mu$m oder 100 $\mu$m aufweist, z.B. nur noch 50 $\mu$m dick ist. Aufgrund des Lasermediums 1 und dessen Dicke in Richtung der Laseremission ist die Struktur zur Erzeugung einer Laseremission mit Femto- oder Pikosekundenpulsen, insbesondere mit Pulsdauern unter 30 ps insbesondere unter 10 ps oder gar unter 1 ps, geeignet, wobei hierfür eine in dieser Figur nicht dargestellte Komponente zur Erzeugung einer Laseremission (LE) mit Femto- oder Pikosekundenpuls-Charakteristik verwendet werden kann, z.B. durch Güteschaltung bzw. einen Q-Switch, wie sie bspw. durch die Verwendung von sättigbaren Absorberstruktur realisiert werden kann.

Damit wird eine fest verbundene und in sich stabile Anordnung für ein sehr dünnes Lasermedium realisiert, wobei das dünne Lasermedium auf einem dickeren Trägermaterial, das aus demselben Materialtyp wie das Lasermedium besteht, aufgebracht, wobei sich eine optische, reflektierende Schichtstruktur dazwischen befindet. Die Anordnung erzielt gegenüber herkömmlichen Strukturen und Pumpverfahren eine erhöhte Effizienz.

Die dem Substrat abgewandte Fläche 1' des Lasermediums ist bevorzugterweise unbeschichtet oder mit einer Antireflexschicht versehen. Je nach Ausführungsform kann diese Fläche 1' auch direkt die sättigbare Absorberstruktur kontaktieren. Die gegenüberliegende Fläche 2' des Substrates 2 als Eintrittsfläche der Pumpstrahlung und Austrittsfläche der Laseremission kann insbesondere mit einer Antireflexbeschichtung für diese beiden verwendeten Wellenlängen versehen werden.

An die Fläche 1' anschliessend kann erfindungsgemäß ebenfalls ein dichroitischer Spiegel als zweiter Resonatorspiegel zwischen dem Lasermedium 1 und der sättigbaren Absorberstruktur angeordnet werden, welcher für die Laseremission zumindest teilweise durchlässig und für die Pumpstrahlung hochreflektierend ausgelegt ist, so dass im wesentlichen nur die Laseremission zur sättigbaren Absorberstruktur geführt wird und dort zum Sättigungsvorgang beiträgt.

Wird eine sättigbare Spiegelstruktur bzw. ein SESAM als sättigbare Absorberstruktur verwendet, so kann diese direkt als der zweite Resonatorspiegel an die Fläche 1' anschließend angeordnet werden, z.B. gebondet oder auch mechanisch mittels Haltevorrichtung in einem geringen und exakt definierten Abstand von bspw. nur wenigen $\mu$m positioniert werden. Dieser SESAM weist bevorzugt eine dichroitische Beschichtung auf, die für die Pumpwellenlänge von 808 nm hochreflektierend ist und für die Laserwellenlänge von 1064 nm eine gegenüber dem unbeschichteten Zustand unveränderte Reflektivität von beispielsweise 30 % besitzt. Im Fall der beabstandeten Positionierung kann der Zwischenraum mit einem Gas, wie z.B. Luft, Vakuum oder einem Füllgas, ausgefüllt werden und eine definierte Dicke aufweisen, sodass der Laserresonator optimiert ist bzw. bei jener Wellenlänge seine Resonanz hat, bei der auch die Verstärkung des Lasermediums als spektrale Laserbedingung maximal ist.

In Fig.2 wird ein zweites Ausführungsbeispiels des erfindungsgemässen Ultrakurzpuls-Mikrochiplasers schematisch dargestellt, das sich dadurch unterscheidet, dass anstelle des undotierten Vanadatsubstrates ein dotiertes Substrat 2a, d.h. ein Nd:Vanadat-Substrat, verwendet wird, wobei aber auch in diesem Ausführungsbeispiel das Substrat 2a, d.h. das Substratmaterial, gegenüber dem Lasermedium 1 bzw. dem verstärkendem Material des Lasermediums niedriger dotiert ist. Die Dotierung wird dabei so gewählt, dass noch genügend Pumplicht am 50 $\mu$m dicken Lasermedium 1 aus Nd:Vanadat ankommt, z.B. bei einer 0,27 % Nd-Dotierung bei 3 mm Dicke.

Dieses zweite Ausführungsbeispiel hat gegenüber dem ersten die Vorteile, dass das Ausgangssignal aus dem Laserresonator durch dotiertes und gepumptes Nd:Vanadat verläuft und somit noch einmal verstärkt wird und die thermische Linse aufgrund des stärker transversal - und weniger longitudinal - verlaufenden Temperaturprofils und der höheren absorbierten Leistung stärker ausgebildet ist und somit eine bessere Modenbildung entstehen kann.

Fig.3 zeigt die Anordnung eines dritten Ausführungsbeispiels des erfindungsgemässen Ultrakurzpuls-Mikrochiplasers in einem erfindungsgemässen Lasersystems.

Hierbei wird Pumplicht bzw. Pumpstrahlung PS über einen dichroitischen Strahlteiler 6 in das Substrat 2 ein- und die erzeugte Laseremission LE ausgekoppelt. Auf der gegenüberliegenden Seite kontaktiert das Lasermedium 1 einen zweiten Resonatorspiegel 4, der für die Pumpwellenlänge reflektierend und für die Wellenlänge der Laseremission LE durchlässig ist und auf einer sättigbaren Absorberstruktur 5 aufgebracht ist. Wie in Fig.2 beschrieben, kann dieser zweite Resonatorspiegel durch eine dichroitische Beschichtung realisiert werden, die für die Pumpwellenlänge von 808 nm hochreflektierend ist und für die Laserwellenlänge von 1064 nm eine gegenüber dem unbeschichteten Zustand unveränderte Reflektivität von beispielsweise 30 % besitzt. Anstelle des zweiten Resonatorspiegels 4 kann eine Reflektion jedoch auch über eine reflektierende Grenzfläche des Lasermediums 1 oder durch totale interne Reflektion im Lasermedium 1 bewirkt werden.

In diesem Ausführungsbeispiel ist der dichroitische Auskoppelspiegel als erster Resonatorspiegel 3a für die optische Pumpstrahlung teilweise reflektierend ausgelegt und zusammen mit einem zweiten Resonatorspiegel 4, so ausgebildet und angeordnet ist, dass Resonanz für die Laseremission und Intensitätsüberhöhung für die Pumpstrahlung auftreten.

Damit ist die dritte Ausführungsvariante mit der Einstellung einer Pumpresonanz zur Erhöhung der Absorption und der Effizienz vergleichbar zur ersten, jedoch sind die beiden Resonatorspiegel 3a und 4 so ausgebildet, dass gleichzeitig Laserresonanz bei der Laserwellenlänge von 1064 nm und eine Intensitätsüberhöhung bzw. Resonanz bei der verwendeten Wellenlänge der Pumpstrahlung PS von z.B. 808 nm vorherrschen. Dies wird dadurch erreicht, dass die Auskoppler-Beschichtung bzw. der dichroitische Auskoppelspiegel 3a nicht mehr hochtransmittierend für die Pumpwellenlänge ist, sondern teilweise reflektierend, je nach erwünschter Resonanz bzw. Intensitätsüberhöhung für die Pumpe innerhalb des Resonators. Die Resonanzen können dabei mittels Auswahl der Phase der Beschichtungen genau eingestellt werden, damit eine doppelte Resonanz bei den beiden Wellenlängen erreicht wird, wobei insbesondere eine Phasenverschiebung von Null zwischen Pumpstrahlungsisophoten und Laseremission am ersten Resonatorspiegel 3a, d.h. dem dichroitischen Auskoppelspiegel, einzustellen ist. Zu beachten ist hierbei, dass Nd:Vanadat bei 808 nm und 1064 nm unterschiedliche Brechzahlen aufweist, was ebenfalls zu berücksichtigen ist.

Der Vorteil dieser Anordnung ist, dass auch bei sehr geringer Dicke ein höherer Leistungseintrag bzw. Absorption in das Lasermedium 1 erreicht werden kann. Ohne diese Optimierung würde die erzielbare Verstärkung und Leistung bei abnehmender Dicke gleichzeitig stark zurückgehen. Darüber hinaus ergibt sich die Möglichkeit, effizienter bei einer Pumpwellenlänge zu pumpen, die eine geringere Absorption aufweist als die Standardpumpwellenlänge von 808 nm, so z.B. bei 880 nm oder 888 nm. Schliesslich ergibt sich auch der Vorteil, dass hierdurch noch dünnere Resonatordicken bzw. -längen deutlich unter 50 $\mu$m möglich werden.

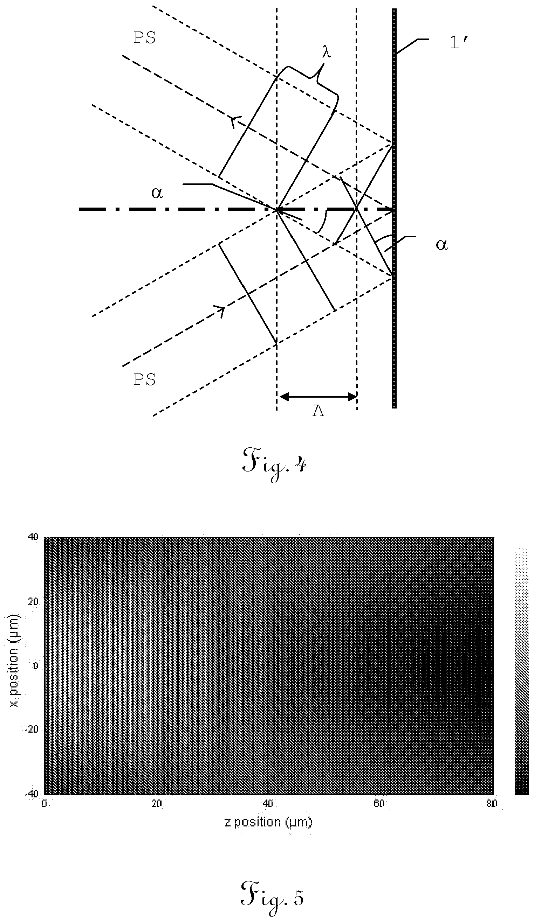

Fig.4 erläutert das Grundprinzip des erfindungsgemässen Pumpverfahrens in schematischer Darstellung. Um bei geringer werdenden Dicken des Lasermediums weiterhin eine ausreichende Leistungsaufnahme zu erreichen, ist es vorteilhaft, die Pumpstrahlung PS so unter einem Winkel $\alpha$ in das Substrat bzw. das Lasermedium einzukoppeln, dass der Überlapp von Pumpstrahlung PS und Laseremission optimiert wird.

Bei der Anwendung dieses Pumpverfahrens kann die restliche Resonatoranordnung wiederum eine Mikrochipanordnung bzw. ein erfindungsgemässer Ultrakurzpuls-Mikrochiplaser sein. Allerdings ist die Anwendung des Pumpverfahrens nicht auf diese Beispiele beschränkt, so dass bspw. auch eine Verwendung für verlängerte Resonatoranordnungen oder für andere Anordnungen mit sehr dünnen Lasermedien möglich ist. Insofern ist dieses Verfahren primär als Pumpanordnung für sehr dünne Lasermedien und ohne notwendige Einschränkung auf erfindungsgemässe Ultrakurzpuls-Mikrochiplaser zu verstehen. Besonders geeignet ist dieses Pumpverfahren allerdings für Lasermedien mit einer Dicke von weniger als 200 μm zur Erzeugung einer Laseremission mit Femto- oder Pikosekundenpulsen, wie sie in den erfindungsgemässen Ultrakurzpuls-Mikrochiplaser verwirklicht werden.

Erfindungsgemäss wird die optische Pumpstrahlung PS unter einem Winkel α so in das Lasermedium eingekoppelt, dass Resonanz für die Laseremission und Intensitätsüberhöhung für die Pumpstrahlung PS auftreten, wobei Wellenlänge und Einfallswinkel α der Pumpstrahlung PS so gewählt bzw. abgestimmt werden, dass die Pumpstrahlungsisophoten als Linien oder Punkte gleicher Helligkeit räumlich einem Intensitätsmuster der durch das Lasermedium zu erzeugenden oder verstärkenden Laseremission entsprechen. Auf der die Rückseite dieses dünnen Lasermediums bildenden Fläche 1' wird die noch nicht absorbierte Pumpstrahlung PS mittels reflektierender Grenzfläche, mittels reflektierendem Beschichtungssytem oder mittels Totaler Interner Reflexion (TIR) zurückgeworfen und erzeugt mit dem einfallenden Strahl der Pumpstrahlung PS ein stehendes Interferenzmuster. Bei geeigneter Wahl der Pumpwellenlänge und des Einfallswinkels α entsprechen die Isophoten bzw. Bäuche der Pumplaserstrahlung, z.B. bei Wellenlängen von 808 oder 880 nm, dem Intensitätsmuster der zu emittierenden Laserstrahlung und überlappen optimal.

In Fig.4 wird die Entstehung des Interferenzmusters veranschaulicht, welches in Form von Isophoten, d.h. maximal gepumpter Ebenen in konstanten Abständen von der reflektierenden Oberfläche, besteht. Die Formel für den Abstand zwischen den Interferenzstreifen bzw. -ebenen ergibt sich aus

$$\Lambda = \frac{\lambda}{2\cos\alpha}$$

wobei λ die Wellenlänge der Pumpstrahlung PS und α deren Einfallswinkel darstellt. Dieser Wert liegt bei einer Pumpwellenlänge von λ = 880 nm und einem Einfallswinkel von α = 34° rechnerisch bei ca. 530 nm, wobei anzumerken ist, dass die optische Dicke, dividiert durch den Brechungsindex n den physikalischen Abstand ergibt, und entspricht somit gut dem Abstand zweier Schwingungsbäuche der zu emittierenden Laserstrahlung mit einer Wellenlänge von 1064 nm (mit ½ · 1064 nm = 532 nm). Bei einer Pumpwellenlänge von λ = 808 nm und Einfallswinkel von α = 40° ergibt sich rechnerisch ebenfalls ein Isophotenabstand von ca. 530 nm (optische Dicke), was somit ebenfalls gut dem Abstand zweier Schwingungsbäuche der Laserstrahlung (½ · 1064 nm = 532 nm optische Länge) entspricht. Diese Beziehung entspricht einer Phasenverschiebung von Null zwischen Pumpstrahlungsisophoten und Laseremission an einem für die Pumpstrahlung PS zumindest teilweise durchlässigen ersten Resonatorspiegel.

In einfachsten Fall ist α = 0°, was einem senkrechten Einfall der Pumpstrahlung PS entspricht. Die einfallende und zurückgeworfene Pumpstrahlung PS ergeben dann ein Interferenzmuster bzw. eine stehenden Welle mit der (optischen) Periode Λ = λ/2. Diese weicht von der Strahlungsverteilung der zu emittierenden Laserstrahlung aufgrund des Wellenlängenunterschiedes in jedem Fall ab, sodass optimal angeregte Bereiche im Lasermedium nicht überall mit dem Strahlungsfeld der zu emittierenden Laserstrahlung übereinstimmen. Dadurch können nicht alle angeregten Ionen in optimaler Weise ihre Energie an die zu emittierende Laserstrahlung abgeben.

Durch optimale Wahl eines Winkels der einfallenden Pumpstrahlung und der Phase zwischen den im Lasermedium sich ergebenden Strahlungsfeldern der Pumpstrahlung PS einerseits und der zu emittierenden Laserstrahlung andererseits wird ein optimierter Überlapp dieser beiden Strahlungsfelder erreicht. Dadurch erhöhen sich die erzielte Verstärkung und die Pumpausbeute. Dieser verbesserte Überlapp sorgt des weiteren dafür, dass parasitäres Lasing mit unerwünschten transversalen oder longitudinalen Moden unterdrückt wird, was andernfalls aufgrund der nicht abgerufenen Inversion und somit vorhandenen Verstärkung leicht entstehen kann.

Fig.5 zeigt ein berechnetes Beispiel eines Pumpintensitätsmusters für die Parameter α = 40,6°, λ = 808 nm, n = 2,16. Der Brechungsindex wird hierbei aus Gründen einer vereinfachten Berechnung als konstant für beide Wellenlängen angesetzt. In der Realität kann die durch die vereinfachende Annahme bewirkte Abweichung von den tatsächlichen Verhältnissen durch eine Feinabstimmung des Winkels berücksichtigt werden. Der aus der Berechnung resultierende Isophotenabstand beträgt dann 532 nm (optische Dicke) und kann somit über einige 10 μm mit den Schwingungsbäuchen der zu emittierenden Strahlung in Phase gehalten werden. Es wird hierbei eine Laserdiode mit einem $M^2 = 1$ in der Zeichnungsebene angenommen. Laserdioden, die wenigstens in einer Richtung eine gute Strahlqualität aufweisen, bieten einen Vorteil, da das Interferenzmuster dann nicht oder weniger "ausgewaschen" ist.

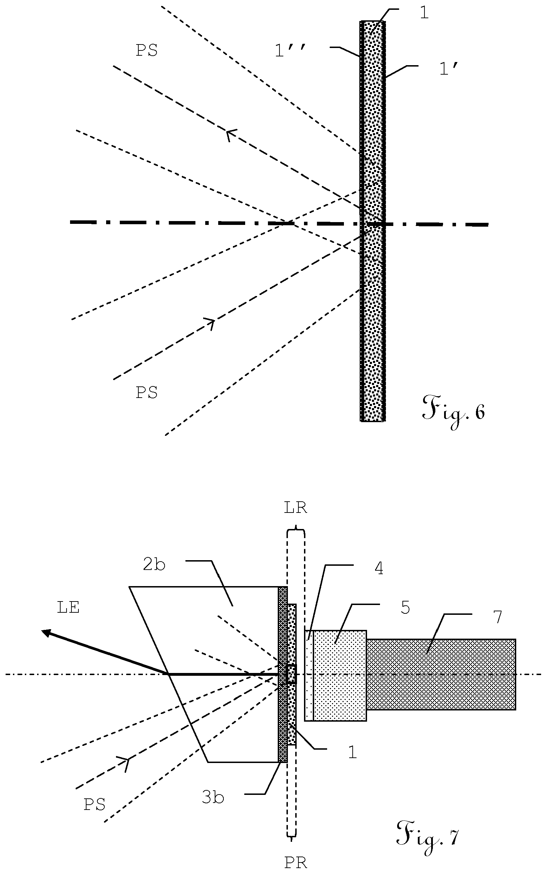

In Fig.6 wird das erfindungsgemässe Pumpverfahren für ein Lasermedium 1 mit zwei reflektierenden (Ober-)Flächen 1' und 1" nochmals veranschaulicht. Für die Übergänge Nd:Vanadat zu Luft ergibt sich ein interner Mindesteinfallswinkel bei dem noch TIR vorherrscht von etwa 28° (n=2.16 bei Polarisation parallel zur c-Achse), Für GaAs gegen Luft ergibt sich ein interner Mindesteinfallswinkel von etwa 17° (jeweils vom Lot).

Fig.7 zeigt die schematische Darstellung eines vierten Ausführungsbeispiels des erfindungsgemässen Ultrakurzpuls-Mikrochiplasers, bei dem das erfindungsgemässe Pumpverfahren genutzt wird. In diesem Ausführungsbeispiel weist das Substrat 2b ein gegenüber der optischen Achse der Laseremission LE aus dem Lasermedium 1 geneigtes Eintrittsfenster für die Pumpstrahlung PS auf, so dass die Pumpstrahlung PS unter einem Pumplichteinfallswinkel gegenüber der optischen Achse der Laseremission LE aus dem Lasermedium 1 in den Ultrakurzpuls-Mikrochiplaser eingekoppelt wird. Entsprechend dem bereits dargestellten Grundprinzip des erfindungsgemässen Pumpverfahrens wird der Pumplichteinfallswinkel so gewählt, dass der Abstand zwischen den Pumpstrahlungsisophoten dem Halbwellenabstand der Laseremission LE im Ultrakurzpuls-Mikrochiplaser entspricht. Die Pumpstrahlung wird hierbei an der Rückseite des Lasermediums durch TIR zurückreflektiert. Da die Pumpstrahlung PS und die Laseremission LE nicht mehr über eine gemeinsame Achse verfügen und somit in ihrem Strahlgang bei der Ein- und Auskopplung getrennt sind, kann auf einen dichroitischen Pumpspiegel verzichtet werden, so dass als erster Resonatorspiegel 3b nur ein reiner Auskoppelspiegel verwendet wird, wobei eine Pumpresonanz möglich ist, wenn der Auskoppelspiegel für die Pumpwellenlänge (teil-)reflektierend ausgeführt wird, was die Absorption und Effizienz erhöht.

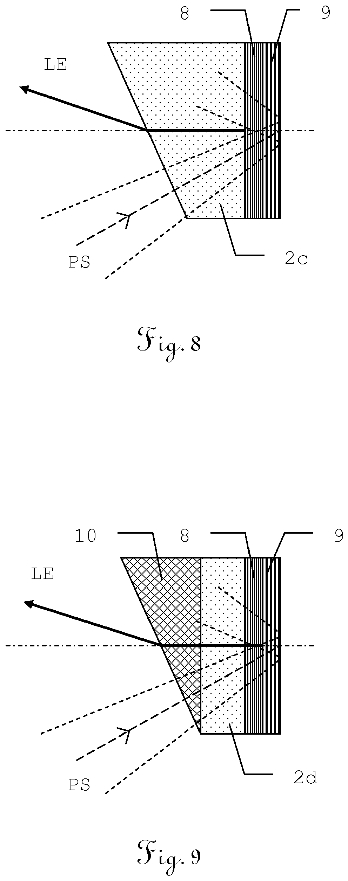

Das geneigte Eintrittsfenster kann, wie hier gezeigt durch einen keilförmigen Abschnitt des Substrats 2b oder durch die in Fig.9 dargestellte aufgebrachte keilförmige Komponente aus Diamant oder aus Substratmaterial ausgebildet werden. Der keilförmige Abschnitt des Substrats kann dabei durch Abschleifen oder Abpolieren erzeugt werden.

Zur Ermöglichung eines Tunings bzw. einer feinabstimmenden Verstellbarkeit ist in diesem Ausführungsbeispiel ein SESAM als sättigbare Absorberstruktur 5 auf einem Piezoelement 7 angeordnet, so dass die Resonanzbedingung für die Laserwellenlänge auf das Maximum der Verstärkungskurve von Nd:Vanadat 1064,3 nm hin eingestellt werden kann. Aufgrund eines gewissen Abstandes zwischen dem Lasermedium und der sättigbare Absorberstruktur 5 ist die evaneszente Welle der Pumpstrahlung der sättigbaren Absorberstruktur 5 abgeklungen, und somit ist keine weitere Beschichtung auf dieser zwecks Reflexion des Restpumplichtes mehr erforderlich, um eine Vorsättigung des durch Pumpstrahlung PS zu vermeiden.

Alternativ zu dem Piezoelement 7 kann jedoch auch ein fixes Abstandselement verwendet werden, z.B. aus $SiO_2$ oder einem ähnlichen Material, das ortsselektiv aufgebracht wird, indem an dem Ort eine Maske verwendet wird, an dem der Laser danach betrieben wird.

Durch diesen Aufbau wird die Pumpresonanz PR durch die Dicke des Lasermediums 1 definiert, wohingegen die Länge des Laserresonators LR durch den zweiten Resonatorspiegel vorgegeben wird.

Ein fünftes Ausführungsbeispiels des erfindungsgemässen Ultrakurzpuls-Mikrochiplasers wird in Fig.8 dargestellt, wobei hier auf einem beidseitig polierten Substrat 2c aus GaAs das Lasermedium und der erste Resonatorspiegel in integrierter Form als für die Laseremission LE hochreflektierender und für die Pumpstrahlung PS und für den gewählten Einfallswinkel zumindest teilweise durchlässiger Braggspiegel 8 mit aufgewachsenen Quantum-Well-Strukturen 9 als Lasermedium ausgebildet sind, wobei die Quantum-Well-Strukturen 9 in der Nähe von Pumpstrahlungsisophoten angeordnet sind. Dabei werden ein oder mehrere Quantum Wells auf den Braggspiegel 8 aufgewachsen, die eine Emission bei der gewünschten Wellenlänge aufweisen, z.B. bei 1064 nm. Die Pumpstrahlung PS, z.B. mit einer Wellenlänge von 980 nm, fällt von der Rückseite über eine geneigtes Eintrittsfenster bzw. über eine Keilfläche in das Substrat 2c ein und hat seinen Fokus auf der Oberfläche des Substrat 2c, auf welcher der Braggspiegel 8 und die Quantum-Well-Strukturen 9 als Verstärkungsmedium angeordnet sind. Durch Totalreflexion wird die (restliche) Pumpstrahlung zurückreflektiert und erzeugt mit der einfallenden Pumpstrahlung PS Interferenzmuster bestehend aus Isophoten als Ebenen maximaler Intensität, die parallel zur Oberfläche und somit zu den Quantum-Well-Strukturen 9 verlaufen. Die Quantum-Well-Strukturen 9 werden nun so positioniert, dass sie sich in der Nähe dieser Pump-Isophoten befinden. Zuvor wird der Einfallswinkel der Pumpstrahlung PS so festgelegt, dass der Abstand zwischen den Isophoten genau dem Halbwellenabstand der Laserstrahlung im Laserresonator entsprechen wird. Bei einem Einfallswinkel von 22° entspricht der optische Abstand der Interferenzebenen rechnerisch

$$\Lambda = \frac{\lambda_{PS}}{2\cos\alpha} = \frac{980nm}{2\cos 22°} = 530nm$$

Somit liegt der physikalische Abstand bei einem Brechungsindex von 3,5 für GaAs bei 150 nm. Bei einem Einfallswinkel von 22° ist TIR an der Grenzfläche zu Luft gegeben.

Alternativ zu einer Ausbildung des Substrates 2c mit einem Keil bzw. einer geneigten Eintrittsfläche oder der Aufbringung von einem GaAs-Keil zwecks Einkopplung kann, wie in Fig. 9 für ein sechstes Ausführungsbeispiels gezeigt, auch ein auf einem flachen Substrat 2d aus GaAs aufgebrachter Diamant-Keil 10 verwendet werden, der neben der rückseitigen Einkopplung der Pumpstrahlung gleichzeitig auch für eine gute Wärmeabfuhr und Wärmeverteilung sorgt.

Der zweite Resonatorspiegel ist in den Fig.8 und 9 aus Veranschaulichungsgründen nicht dargestellt, kann aber in zu Fig.7 analoger Weise ausgebildet und angeordnet sein. Dieser kann damit wieder mittels Gas oder Vakuum vom ersten Resonatorspiegel in einem Abstand angeordnet sein, oder aber er kann mittels niedrigbrechenden Abstandsschichten vorbestimmter Dicke, wie z.B. $SiO_2$ mit einem Brechungsindex von n = 1,4, direkt an die aktiven Schichten angebondet werden. Zu beachten ist hierbei, dass bei Verwendung von Abstandsschichten der TIR-Mindestwinkel grösser wird:

dieser beträgt beim Übergang von GaAs (n = 3,5) zu SiO$_2$ (n = 1,4) etwa 24° vom Lot, und beim Übergang von Nd:Vanadat (n = 2,16 parallel zu c) zu SiO$_2$ (n = 1,4) nunmehr 40°. Zu beachten ist weiterhin, dass bei Verwendung einer SiO$_2$-Abstandsschicht anstelle von Luft oder Vakuum die evaneszente Welle weniger schnell abklingt und diese somit dicker auszuführen ist.

Anstelle der Quantum-Well-Strukturen 9 können jedoch auch andere Halbleitermaterialien bzw. -strukturen verwendet werden, so können bspw. sogenannte Quantum Dots oder auch nicht-strukturiertes Halbleitermaterial als Verstärkungsmedium verwendet werden. Der Schichtaufbau der integrierten Komponente wird in Fig.9 anhand der tabellierten Darstellung der Schichtfolgen für das fünfte und sechste Ausführungsbeispiel näher erläutert.

In diesem Beispiel kann ein, beispielsweise resonanter Quantum-Well- oder Quantum-Dot-Absorber die Funktion des sättigbaren Absorbers übernehmen, so dass Pikosekundenlaserpulse mit Pulslängen von weniger als 30 ps, weniger als 10 ps oder sogar kürzer als 1 ps entstehen.

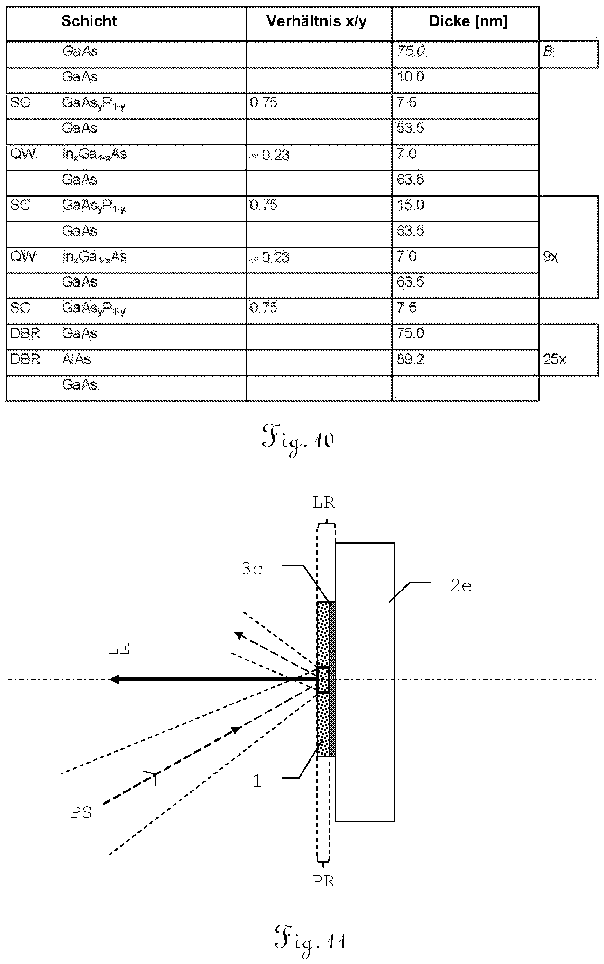

Fig.10 zeigt, wie eine Schichtfolge der Halbleiterstruktur konkret gestaltet werden kann, wobei in dieser Darstellung im Vergleich zu den Fig.8 und 9 eine umgekehrte Reihenfolge gewählt ist, d.h. zuoberst ist Luft und zuunterst das GaAs-Substrat. Die Quantum-Wells QW werden in ihren Schichtdicken und im Indiumgehalt auf die Zielvorgabe genau eingestellt, sodass die Photolumineszenz bzw. die Emission ein Maximum bei 1064 nm hat, wobei die im Betrieb entstehende Erwärmung berücksichtigt ist. Die Schichtdicke der abschliessenden Schicht B wird so eingestellt, dass die Pumpstrahlung ein mit den Quantum-Wells QW überlappendes Intensitätsmuster ausbildet. SC bezeichnet in dieser Fig. 9 eine Halbleiterschicht und DBR ("Distributed Bragg Reflector") den Braggreflektor. Rechts anschliessend an die Tabelle ist die Zahl der Wiederholungen der jeweiligen Schichtfolgen angegeben, so weist beispielsweise der BraggReflektor insgesamt 25 GaAs/AlAs-Schichtpaare auf.

Wird an die aktive Schichte anstelle der oben angeführten niedrigbrechenden Abstandsschicht SiO$_2$ oder anstelle von Luft, Gas oder Vakuum zwecks verbesserter Kühlung nunmehr Diamant direkt anschliessend angeordnet, so ergibt sich zwischen GaAs und Diamant ein TIR-Mindesteinfallswinkel von etwa 44°. Damit verschiebt sich die mögliche Laserwellenlänge mit optimalem Pumpstrahlungs- und Laseremissionsüberlapp zu Werten deutlich grösser als 1064 nm, z.B. folgt bei einem Einfallswinkel von α = 50° und einer Wellenlänge der Pumpstrahlung von λ$_{PS}$ = 980 nm eine Wellenlänge der Laseremission von λ$_{LE}$ = 1,5 μm.

Fig.11 zeigt die schematische Darstellung eines siebten Ausführungsbeispiels des erfindungsgemässen Ultrakurzpulslasersystems. In diesem Ausführungsbeispiel erfolgt die Strahlführung für die Pumpstrahlung nicht durch das Substrat 2e hindurch, sondern von der gegenüberliegenden Seite her. Die Pumpstrahlung PS fällt unter einem Pumplichteinfallswinkel gegenüber der optischen Achse der Laseremission LE in das dünne Lasermedium 1 der Laseranordnung ein. Der nicht absorbierte Anteil der Pumpsstrahlung PS wird durch die rückseitig, d.h. zwischen dem dünnen Lasermedium 1 und dem Substrat 2e liegenden ersten Resonatorspiegel 3c reflektiert, wodurch ein Interferenzmuster bzw. ein Pumpstrahlungsisophotenmuster entsteht. Dieser erste Resonatorspiegel 3c ist auch für die Laseremissionswellenlänge hoch- oder mindestens teilreflektierend. Entsprechend dem bereits dargestellten Grundprinzip des erfindungsgemässen Pumpverfahrens wird der Pumplichteinfallswinkel so gewählt, dass der Abstand zwischen den Pumpstrahlungsisophoten dem Halbwellenabstand der Laseremission LE im dünnen Lasermedium 1 entspricht. Die Pumpstrahlung PS wird hierbei an der Rückseite des Lasermediums 1 durch Reflexion am ersten Resonatorspiegel 3c zurückreflektiert. Da die Pumpstrahlung PS und die Laseremission LE nicht mehr über eine gemeinsame Achse verfügen und somit in ihrem Strahlgang bei der Ein- und Auskopplung getrennt sind, kann auf einen dichroitischen Pumpspiegel zur Trennung verzichtet werden.

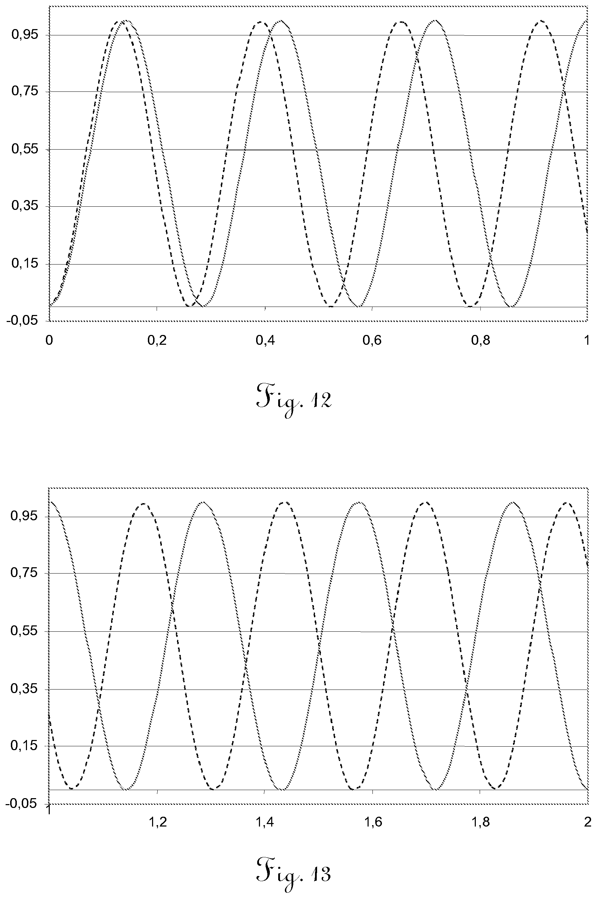

Die Strahlungsfelder der Pump- und Laserstrahlung sind für den Fall eines Einfallswinkels α = 0° entlang der Propagationsachse im Beispiel eines diodengepumpten Yb:YAG-Lasers in Fig.12 und Fig.13 dargestellt, wobei in beiden Figuren horizontal die physikalische Länge als Propagationsachse in μm und vertikal das Strahlungsfeld jeweils für die Pumpstrahlung (gestrichelte Linie) und die Laseremission (durchgezogene Linie) angegeben sind. Hierbei werden eine Pumpwellenlänge von 940 nm, eine Laserbetriebswellenlänge von 1030 nm und ein 50 μm dickes Lasermedium zugrundegelegt. An der Position Null sind die beiden Strahlungsfelder mit gleicher Phase dargestellt, was einer vorgegebenen Stelle in der Schichtstruktur entsprechen kann. Entlang der Propagationsachse z innerhalb des Lasermediums beginnen die beiden Strahlungsfelder danach rasch auseinanderzulaufen, so dass der Überlapp z.B. an der Stelle z = 1,5 μm "ausser Phase" ist bzw. eine Pumpstrahlungsisophote einen Wellenknoten der Laseremissionsstrahlung trifft, was in Fig.13 veranschaulicht wird. Gemäss der Forderung

$$\Lambda = \frac{\lambda}{2\cos\alpha}$$

wird bei einem internen, d.h. im Lasermedium angenommenen Pumpeinfallswinkel von α = 24,1° ein über die Dicke des Lasermediums von 50 μm erhaltener Überlapp der Strahlungsfelder gewährleistet, so dass diese nicht auseinanderlaufen. Dies entspricht einem externen Pumpstrahlungseinfallswinkel von 47,3° vom Lot, wobei für Yb:YAG ein Brechungsindex von n = 1,8 zugrundegelegt wird.

Darüber hinaus ist eine Anordnung zwecks Pumpresonanz bzw. Pumpintensitätsüberhöhung möglich, wenn optional auf der Vorderseite des dünnen Lasermediums ein (teil-) reflektierendes Element aufgebracht wird, dessen Phase so gewählt wird, dass bei der Pumpwellenlänge eine Intensitätsüberhöhung im Lasermedium stattfindet. Dies erhöht die effektive Pumpabsorption und Effizienz. Durch diesen Aufbau wird die Pumpresonanz durch die Dicke des Lasermediums definiert, wohingegen die Länge des Laserresonators durch den zweiten Resonatorspiegel vorgegeben wird.

Das Substrat kann aus demselben Materialtyp wie das Lasermedium bestehen oder aber aus einem demgegenüber besser wärmeleitenden Material, wie z.B. Diamant ausgebildet werden. Eine aktive Kühlung der Rückseite des Substrates, z.B. mittels Wasser, führt zu einer Anordnung, die einem Thin-Disk-Laser-Aufbau ähnelt, jedoch erfindungsgemäß eine abweichende Führung des Pumplichtes unter einem bestimmten Einfallswinkel aufweist.

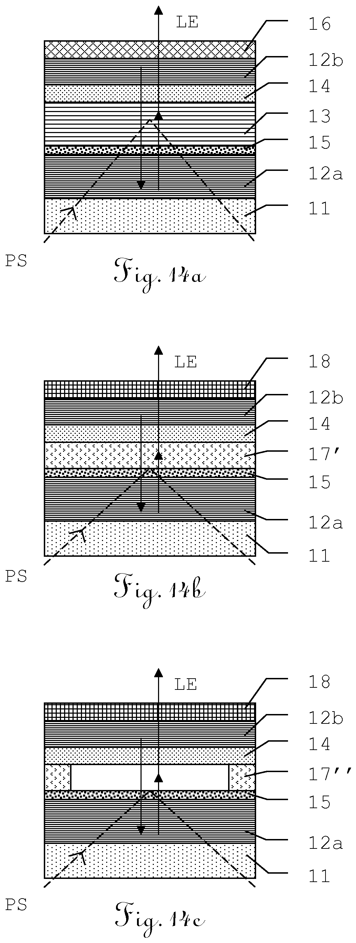

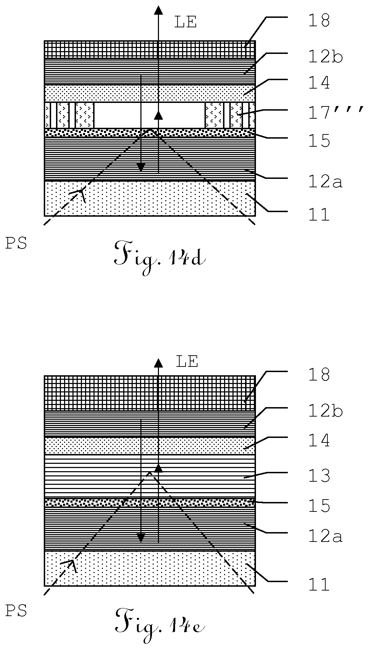

In den Fig.14a-e werde Ausführungsbeispiele erfindungsgemässer vertikal emittierender Halbleiterlaser schematisch dargestellt, welche durch ihren Aufbau das erfindungsgemässe Pumpverfahren nutzen. In den nachfolgend dargestellten Ausführungsbeispielen handelt es sich um kreisgütemodulierte bzw. Q-switched Laser, wobei der Laserresonator so kurz wie nur technisch möglich ausgelegt ist, so dass aufgrund dieser geringen Resonatorlänge eine gütegeschaltete Pulslänge im Bereich von 1 ps oder sogar darunter entstehen kann. Es handelt sich also um einen vertikal emittierenden (Quantum Well) optisch gepumpten Halbleiterlaser - Vertical Cavity Semiconductor Laser (VCSEL) und damit einen Optically Pumped Semiconductor Laser (OPSL).

Allen Ausführungsbeispielen ist ein Aufbau mit einem Substrat 11, z.B. aus GaAs, zwei Resonatorspiegeln 12a und 12b, einer sättigbaren Absorberstruktur 14, z.B. Quantum Dots, sowie einem verstärkendem Lasermedium 15 gemeinsam.

Im Gegensatz zu ähnlichen Anordnungen des Stands der Technik ist der Resonator sehr kurz und wird nicht modengekoppelt sondern gütemoduliert bzw. Q-switched betrieben.

Dieser Aufbau basiert darauf, dass eine höhere sättigbare Absorption des sättigbaren Absorbers pro Resonatorumlauf eingestellt und die Resonatorlänge so kurz wie nur möglich gemacht wird, z.B. weniger als 50 optische Halbwellenlängendicken bzw. weniger als 150 μm, was einer Umlaufpulswiederholrate von über 1 THz entspricht, so dass der Laser von selbst im Q-switched-Betrieb läuft. Ein solcher Laserbetrieb hat den Vorteil, dass Pulse mit höherer Energie und geringerer Repetitionsrate erzeugt werden, wodurch einige Anwendungen besser bedient werden und die Pulse mit einem elektro-/akustooptischen Schalter leichter getrennt werden können. Im Gegensatz dazu ist bei den modengekoppelten OPSLs wegen der kurzen Resonatorlänge üblicherweise die Repetitionsrate im Bereich GHz oder Multi-GHz, wodurch die Pulsenergie geringer wird (sub-nJ) und der Abstand zwischen den Pulsen sehr kurz ist.

Wird die Halbleiterlaserstruktur gepulst gepumpt, so ist zudem die Wärmelast geringer, was gerade beim OPSL zu starken Vereinfachungen führt. In solchen Anordnungen wird ansonsten oft mit Diamant, z.T. sogar mit Intracavity-Diamant, gearbeitet, wodurch die erreichbare Leistung deutlich steigt, was jedoch aufwendig und teuer ist

Gepulstes Pumpen erleichtert die Kühlung, sofern eine hierdurch reduzierte Pulsrepetitionsrate in der Anwendung gehandhabt werden kann, was aber bspw. bei der Verwendung von Saatpulsen kein Problem darstellt. Der Pumppuls kann dann aufgrund der geringen Speicherzeit - im Quantum Well - von wenigen Nanosekunden ebenfalls nur wenige Nanosekunden betragen. Eine wesentliche Reduktion der eingetragenen Wärme ist dann aber schon erreichbar, wenn die Pumppulsfrequenz im Bereich von einigen 10 MHz liegt und somit im Bereich der handelsüblichen modengekoppelten Lasern.

In der Fig.14a wird nun ein erstes Ausführungsbeispiel eines erfindungsgemässen vertikal emittierender Halbleiterlasers dargestellt, bei dem der Pumpstrahl bzw. die Pumpstrahlung PS vom Halbleitersubstrat 11 her durch den ersten Resonatorspiegel 12a hindurch in die OPSL-Struktur eintritt. Dabei muss in Hinblick auf die energetischen Verhältnisse die Wellenlänge über der Bandlücke des Substratmateriales liegen. Je nach erwünschtem (internem) Winkel ist ein abgeschrägtes Eintrittsfenster vorteilhaft oder nötig, wie in den vorangehenden Figuren dargestellt. Die Pumpstrahlung PS wird an einem epitaktisch aufgebrachten Pumpspiegel 13 reflektiert. Eine Polarisation in s-Richtung (E-Feld senkrecht zur Zeichnungsebene) kann von Vorteil sein, weil dadurch die Reflektivität in dem als Bragg-Spiegel ausgestaltetem Pumpspiegel 13 bei geringerer Anzahl von Braggpaaren gewährleistet werden kann als bei p-Polarisation. Die resultierende stehende Pumpstrahlung PS führt im Verstärkerabschnitt dazu, dass das Verstärkermedium 15, z.B. aus Quantum Wells o.ä. gepumpt wird, wobei es vorteilhaft ist, wenn die Quantum Wells nahe den Pumpisophotenmaxima liegen. Die Pumpstrahlung PS kommt hierbei nicht über den Bereich des Pumpspiegels 13 hinaus, so dass der dort liegende sättigbare Absorber 14, bevorzugt bestehend aus Quantum Dots, nicht ausgebleicht wird. Die beiden Resonatorspiegel 12a und 12b bilden die Kavität für die entstehende Laseremission LE, wobei ein Teil davon ausgekoppelt werden kann. Die Phase der Resonatorspiegel 12a und 12b sowie des Pumpspiegels 13, und die Lage der Quantum Wells als Lasermedium 15 sowie der Quantum Dots als sättigbarem Absorber 14 sollten so aufeinander abgestimmt werden, dass Lasermedium 15 und Absorber 14 jeweils nahe oder in einem (lokalen) Feldmaximum liegen, jedenfalls nicht direkt in einem Feldminimum, wobei dieses beim Lasermedium 15 gleichzeitig für Pumpstrahlung PS und Laseremission LE gilt.

In dieser Struktur kann gepulstes Pumpen von besonderem Vorteil sein, so dass das optionale Diamantstück 16 oder anderweitig stark wärmeleitendes, gegebenenfalls auch durchsichtige, Kühlmaterial auf dem Resonatorspiegel 12b entfallen kann. Der Resonatorspiegel 12b kann in diesem Fall auch aus herkömmlichen Beschichtungsmaterialien bestehen. Alle anderen Schichten oder Bereiche bestehen bevorzugt aus Halbleitermaterial wie GaAs, InGaAs, AlAs, AlGaAs oder ähnlichen Materialien.

Das in Fig.14b gezeigte zweite Ausführungsbeispiel entspricht dem ersten grundsätzlich im Aufbau, wobei allerdings die Pumpstrahlung PS hier mittels Reflektion an der Oberfläche einer Abstandsschicht (Spacer) 17' als Pumpreflektor zurückreflektiert wird und zu einer Verwertung der reflektierten Pumpstrahlung PS und somit erhöhten Effizienz führt. Diese Reflektion kann bei entsprechendem Winkel mittels Totalreflexion (TIR) an der Oberfläche bewerkstelligt werden, oder aber mittels Pumpreflektor, der in Form eines Schichtpaketes aufgebracht wird, wiederum mit Halbleitermaterialien oder mit beschichteten, bedampften, usw. dielektrischen Schichten. Dieser Pumpreflektor soll für die Laserstrahlung durchlässig sein oder teildurchlässig sein.

Die Abstandsschicht 17' kann aus Luft, Gas, oder aus einem dielektrischen Material bestehen. In allen diesen Fällen, d.h. auch im Falle des dielektrischen Materials als Abstandsschicht 17', kann nach wie vor die Totalreflexion als Mechanismus für den Pumpreflektor verwendet werden, da der Brechungsindexunterschied zwischen GaAs und $SiO_2$ immer noch sehr hoch ist (3.5 gegenüber 1.46) und Totalreflexion somit schon bei geringen Einfallswinkeln auftreten kann.

Bei Verwendung einer dielektrischen Abstandsschicht 17' ist es möglich, die Gesamtstruktur monolithisch aufzubauen. Im Fall von Luft oder Gas als Abstandsschicht 17' ist es möglich, eine der beiden Hälften der Gesamtstruktur mittels Piezoelement in der Position laufend präzise einzustellen, so dass der Laser optimal betrieben werden kann, z.B. im Leistungsmaximum.

Die zweite Hälfte des Lasers besteht aus einer SESAM-Halbleiterstruktur (Semiconductor Saturable Absorber Mirror) 14, wobei im oder nahe beim Schwingungsbauch der Laseremission LE Quantum Dots mit einer sättigbaren Absorption bei der Wellenlänge der Laseremission LE angeordnet sind. Ein Braggspiegel z.B. aus GaAs/AlGaAs, der eine Anzahl von Braggpaaren aufweist, sodass ein Teil der Strahlung den Laser verlässt, schliesst - als Teil dieses sättigbaren Absorbers 14 - den Resonator für die Laseremission LE ab. In diesem Fall tritt die (gepulste) Laseremission LE durch das GaAs-Substrat 18 aus, das bevorzugt mit einer Antireflex-Beschichtung versehen ist. Die Modenformung entsteht durch das Brechungsindexprofil aufgrund der entstehenden Temperaturverteilung, in diesem konkreten Fall jedoch zusätzlich aus den (positiven) Linsen, die sich durch die thermisch bedingte Wölbung der Oberflächen in das gas-/luft-gefüllte Volumen der Abstandsschicht 17' hinein ergeben.

Die in Fig.14c dargestellte Struktur ist ganz analog zur vorherigen ausgebildet, wobei als Abstandsschicht 17" ein mit bestimmter Dicke aufgebrachtes Material eine Verbindung zwischen den beiden durch Luft oder ein Gas getrennte Hälften herstellt, somit mechanisch verbindet und die Gesamtstruktur strukturell zu einem monolithischen Laser zusammenfügt.

Auch die in Fig.l4d gezeigte Anordnung zeigt einen zu den vorhergehenden Ausführungsbeispielen grundsätzlich gleichen Aufbau, wobei hier die Abstandsschicht 17''' eine modenformende Funktion übernimmt und somit aus transparentem und strukturiertem dielektrischen Material, wie z.B. $SiO_2$, besteht. Dadurch kann die gewünschte optische Wirkung (zum Beispiel Fokuslänge) eingestellt werden, ganz analog zur Fresnel-Linse oder Zonenplatte. Wichtig ist dann allerdings, dass die Lage der Pumpstrahlung PS auf den Ort dieses diffraktiven Elementes abgestimmt wird und z.B. in die Mitte dieser Zonenplatte fällt. Dicke und Muster der Segmente der Abstandsschicht 17''' können vorteilhafterweise eingestellt werden.

Bei dem Ausführungsbeispiel der Fig.14e handelt es sich um eine Struktur, die auf einem GaAs-Substrat 18 oder anderem Halbleitersubstrat aufgebracht ist (von oben nach unten): Darauf wird der Resonatorspiegel 12b in Form eines Braggspiegels für die Laserstrahlung von z.B. 1064nm aufgebracht. Auf diesem Braggspiegel werden Schichten von Quantum Dots aufgebracht, die in den Wellenbäuchen der Laserstrahlung liegen, die vom Resonatorspiegel 12b reflektiert werden. Ein Pumpspiegel 13, wiederum bestehend aus epitaktischen Schichten wie AlGaAs und AlAs, reflektiert die Pumpstrahlung PS und transmittiert einen Grossteil der Laseremission LE, sodass dieses erst beim Resonatorspiegel 12b reflektiert wird und in den Quantum Dots als sättigbarem Absorber 14 eine Absorption erfährt. Schliesslich befinden sich auf dem Pumpspiegel 13 als Lasermedium 15 die Verstärkungsschichten in Form von Quantum Wells, ebenfalls angeordnet in oder nahe bei Schwingungsbäuchen sowohl der Pumpstrahlung PS als auch der Laseremission LE. Schliesslich wird der Laserresonator mit einem dichroitischen Pumpspiegel 12a als Auskoppler abgeschlossen, bestehend aus Halbleitermaterial oder aus herkömmlichen dielektrischen Beschichtungsmaterialien wie $SiO_2$, $Ta_2O_5$, $TiO_2$, die durch Beschichten, Sputter-Coating oder Bedampfen aufgebracht werden. Hierbei wird eine Transmission für die Pumpwellenlänge eingestellt und es kann auch durch partielle Reflektion der Laseremission LE eine Auskopplung der Laserstrahlung erreicht werden.

Dieses Ausführungsbeispiel ist kürzer und somit kurzpulsiger als die vorherigen, weil als einer der Resonatorspiegel 12a oder 12b ein herkömmlicher dielektrischer Spiegel verwendet werden kann, der mit weniger Eindringtiefe höhere Reflektivität erreicht als ein Halbleiterbraggspiegel, wodurch nochmals Resonatorlänge eingespart werden kann. Zudem ist eine Kühlung mittels, ggf. transparentem, Kühlkörper wie Diamant möglich ist, was bei anderen Anordnungen mit zwei GaAs-Substraten schwerer möglich ist.

**Patentansprüche**

1. Optisch gepumpter Ultrakurzpuls-Mikrochiplaser zur Erzeugung von Femto- oder Pikosekundenpulsen, insbesondere mit Pulsdauern unter 30 ps, unter 10 ps oder unter 1 ps, mit mindestens

     • einem Substrat (2,2a,2b,2c,2d,2e), insbesondere aus Vanadat,
     • einem verstärkenden Lasermedium (1) zur Erzeugung der Laseremission (LE), insbesondere dotiertem Vanadat, vorzugsweise Nd:Vanadat mit einer Dotierung von mehr als 1 % Nd,
     • einem für optische Pumpstrahlung (PS) zumindest teilweise durchlässigen ersten Resonatorspiegel (3,3a,3b,3c),
     • einer Komponente zur Erzeugung einer Laseremission (LE) mit Femto- oder Pikosekundenpuls-Charakteristik, insbesondere einer sättigbaren Absorberstruktur (5), so ausgebildet und angeordnet, dass der Ultrakurzpuls-Mikrochiplaser gütegeschaltet ist, wobei
     • das Substrat (2,2a,2b,2c,2d,2e) und das Lasermedium (1) aus demselben Material ausgebildet sind und das Substrat (2,2a,2b,2c,2d,2e) gegenüber dem Lasermedium (1) niedriger dotiert ist, insbesondere undotiert ist, und
     • das Substrat (2,2a,2b,2c,2d,2e), das Lasermedium (1) und der erste Resonatorspiegel (3,3a,3b,3c), insbesondere die Komponente zur Erzeugung einer Laseremission (LE) mit Femto- oder Pikosekundenpuls-Charakteristik, miteinander verbunden sind, wobei
     • das Lasermedium (1) eine Dicke in Richtung der Laseremission von weniger als 200 $\mu$m aufweist, insbesondere von weniger als 100 $\mu$m,
     • der erste Resonatorspiegel (3,3a) ein zwischen dem Substrat (2,2a,2b,2c,2d) und dem Lasermedium (1) angeordneter dichroitischer Auskoppelspiegel ist, welcher für die Laseremission (LE) und für die Pumpstrahlung (PS) zumindest teilweise durchlässig ausgelegt ist und der dichroitische Auskoppelspiegel für die optische Pumpstrahlung (PS) teilweise reflektierend ist und zusammen mit

         o einem zweiten Resonatorspiegel (4),
         o einer reflektierenden Grenzfläche des Lasermediums oder
         o totaler interner Reflektion im Lasermedium (1)
     so ausgebildet und angeordnet ist, dass
         o Resonanz für die Laseremission (LE) und

         o Intensitätsüberhöhung für die Pumpstrahlung (PS)
     auftreten, und

     • das Substrat (2,2a,2b,2c,2d,2e) eine, insbesondere erheblich, grössere Dicke in Richtung der Laseremission aufweist als das Lasermedium (1).

2. Ultrakurzpuls-Mikrochiplaser nach Anspruch 1, **dadurch gekennzeichnet, dass** das Lasermedium (1) eine nach Verbindung mit dem Substrat (2,2a,2b,2c,2d,2e) in ihrer ursprünglichen Materialstärke reduzierte Komponente ist.

3. Ultrakurzpuls-Mikrochiplaser nach Anspruch 2, **dadurch gekennzeichnet, dass** das Lasermedium (1) ein nach Verbindung mit dem Substrat (2,2a,2b,2c,2d,2e) abgeschliffene und/oder abpolierte Komponente ist.

4. Ultrakurzpuls-Mikrochiplaser nach einem der vorangehenden Ansprüche, **dadurch gekennzeichnet, dass** ein dichroitischer Spiegel als zweiter Resonatorspiegel (4) zwischen dem Lasermedium (1) und der als sättigbare Absorberstruktur ausgebildeten Komponente zur Erzeugung einer Laseremission (LE) mit Femto- oder Pikosekundenpuls-Charakteristik angeordnet ist, welcher für die Laseremission (LE) zumindest teilweise durchlässig und für die Pumpstrahlung (PS) hochreflektierend ausgelegt ist.

5. Ultrakurzpuls-Mikrochiplaser nach einem der vorangehenden Ansprüche, **dadurch gekennzeichnet, dass** ein Resonatorelement, insbesondere die sättigbare Absorberstruktur (5), auf einem Piezoelement (7) angeordnet ist.

6. Ultrakurzpuls-Mikrochiplaser nach einem der vorangehenden Ansprüche, **gekennzeichnet durch** ein gegenüber der optischen Achse der Laseremission (LE) aus dem Lasermedium (1) geneigtes Eintrittsfenster.

7. Ultrakurzpuls-Mikrochiplaser nach Anspruch 6, **dadurch gekennzeichnet, dass** das geneigte Eintrittsfenster durch einen keilförmigen Abschnitt des Substrats (2b,2c,2d) oder durch eine aufgebrachte keilförmige Komponente aus Diamant (10) oder aus Substratmaterial ausgebildet ist.

8. Ultrakurzpuls-Mikrochiplaser nach einem der vorangehenden Ansprüche, **dadurch gekennzeichnet, dass**

auf dem Substrat (2c,2d) das Lasermedium und der erste Resonatorspiegel in integrierter Form als für die Laseremission (LE) hochreflektierender und für die Pumpstrahlung zumindest teilweise durchlässiger Braggspiegel (8) mit aufgewachsenen Quantum-Well-Strukturen (9) als Lasermedium ausgebildet sind, wobei die Quantum-Well-Strukturen (9) in der Nähe von Pumpstrahlungsisophoten angeordnet sind.

9. Ultrakurzpuls-Mikrochiplaser nach einem der vorangehenden Ansprüche,
   **dadurch gekennzeichnet, dass**
   die Komponente zur Erzeugung einer Laseremission (LE) als sättigbaren Absorberstruktur (5) so ausgebildet und angeordnet ist, dass der Ultrakurzpuls-Mikrochiplaser gütegeschaltet ist.

10. Lasersystem mit einem Ultrakurzpuls-Mikrochiplaser nach einem der Ansprüche 1 bis 9,
    **dadurch gekennzeichnet, dass**
    die Pumpstrahlung (PS) unter einem Pumpstrahlungseinfallswinkel gegenüber der optischen Achse der Laseremission (LE) aus dem Lasermedium (1) in den Ultrakurzpuls-Mikrochiplaser eingekoppelt wird.

11. Lasersystem nach Anspruch 10,
    **dadurch gekennzeichnet, dass**
    der Pumpstrahlungsfallswinkel so gewählt ist, dass der Abstand zwischen Pumpstrahlungsisophoten dem Halbwellenabstand der Laseremission (LE) im Ultrakurzpuls-Mikrochiplaser entspricht.

12. Pumpverfahren zur Erzeugung einer Laseremission (LE) mit Femto- oder Pikosekundenpulsen, mit mindestens

    • einem Substrat (2,2a,2b,2c,2d,2e), insbesondere aus Vanadat,
    • einem verstärkenden Lasermedium (1) zur Erzeugung der Laseremission (LE), insbesondere dotiertem Vanadat, vorzugsweise Nd:Vanadat mit einer Dotierung von mehr als 1 % Nd,
    • einem für optische Pumpstrahlung (PS) zumindest teilweise durchlässigen ersten Resonatorspiegel (3,3a,3b,3c),
    • einer Komponente zur Erzeugung einer Laseremission (LE) mit Femto- oder Pikosekundenpuls-Charakteristik, insbesondere einer sättigbaren Absorberstruktur (5), so ausgebildet und angeordnet, dass eine Güteschaltung bereitgestellt ist,
    wobei.
    das Substrat (2,2a,2b,2c,2d,2e) und das Lasermedium (1) aus demselben Material ausgebildet sind und das Substrat (2,2a,2b,2c,2d,2e) gegenüber dem Lasermedium (1) niedriger dotiert ist, insbesondere undotiert ist, und das Substrat (2,2a,2b,2c,2d,2e), das Lasermedium (1) und der erste Resonatorspiegel (3,3a,3b,3c), insbesondere die Komponente zur Erzeugung einer Laseremission (LE) mit Femto- oder Pikosekundenpuls-Charakteristik, miteinander verbunden sind und
mit wenigstens einem Einkoppeln von optischer, insbesondere gepulster Pumpstrahlung (PS) in das Lasermedium (1), wobei

• das Lasermedium (1) eine Dicke in Richtung der Laseremission von weniger als 200 $\mu$m aufweist, insbesondere von weniger als 100 $\mu$m,
• der erste Resonatorspiegel (3,3a) zwischen dem Substrat (2,2a,2b,2c,2d) und dem Lasermedium (1) angeordnet ist,
• das Substrat (2,2a,2b,2c,2d,2e) eine, insbesondere erheblich, grössere Dicke in Richtung der Laseremission aufweist als das Lasermedium (1),
• der erste Resonatorspiegel (3,3a) ein zwischen dem Substrat (2,2a,2b,2c,2d) und dem Lasermedium (1) angeordneter dichroitischer Auskoppelspiegel ist, welcher für die Laseremission (LE) und für die Pumpstrahlung (PS) zumindest teilweise durchlässig ausgelegt ist und der dichroitische Auskoppelspiegel für die optische Pumpstrahlung (PS) teilweise reflektierend ist und zusammen mit

   ◦ einem zweiten Resonatorspiegel (4),
   ◦ einer reflektierenden Grenzfläche des Lasermediums oder
   ◦ totaler interner Reflektion im Lasermedium (1)
   so ausgebildet und angeordnet ist, dass
   ◦ Resonanz für die Laseremission (LE) und
   ◦ Intensitätsüberhöhung für die Pumpstrahlung (PS) bereitstellbar sind und
• die optische Pumpstrahlung (PS) so in das Lasermedium (1) eingekoppelt wird, dass

   ◦ die Resonanz für die Laseremission (LE) und
   ◦ die Intensitätsüberhöhung für die Pumpstrahlung (PS)

auftreten, insbesondere indem Wellenlänge und Einfallswinkel der Pumpstrahlung (PS) so gewählt werden, dass Pumpstrahlungsisophoten einem Intensitätsmuster der Laseremission (LE) entsprechen.

13. Pumpverfahren nach Anspruch 12,
    **dadurch gekennzeichnet, dass**
    eine Phasenverschiebung von Null zwischen Pumpstrahlungsisophoten und Laseremission (LE) an einem für die Pumpstrahlung (PS) zumindest teilweise durchlässigen ersten Resonatorspiegel (3,3a,3b) gegeben ist.

## Claims

1. Optically pumped ultrashort pulse microchip laser for generating femto- or picosecond pulses, in particular with pulse durations of less than 30 ps, less than 10 ps or less than 1 ps, having at least

   • a substrate (2, 2a, 2b, 2c, 2d, 2e), in particular of vanadate,
   • an amplifying laser medium (1) for generating the laser emission (LE), in particular doped vanadate, preferably Nd:vanadate with a doping of more than 1% Nd,
   • a first resonator mirror (3, 3a, 3b, 3c) at least partially transparent for optical pump radiation (PS),
   • a component for generating a laser emission (LE) with femto- or picosecond pulse characteristics, in particular a saturable absorber structure (5), constructed and arranged such that the ultrashort pulse microchip laser is Q-switched, wherein
   • the substrate (2, 2a, 2b, 2c, 2d, 2e) and the laser medium (1) are formed from the same material and the substrate (2, 2a, 2b, 2c, 2d, 2e) is doped to a lower level than the laser medium (1), in particular undoped, and
   • the substrate (2, 2a, 2b, 2c, 2d, 2e), the laser medium (1) and the first resonator mirror (3, 3a, 3b, 3c), in particular the component for generating a laser emission (LE) with femto- or picosecond pulse characteristics, are connected to one another,
   wherein
   • the laser medium (1) has a thickness in the direction of laser emission of less than 200 $\mu$m, in particular less than 100 $\mu$m,
   • the first resonator mirror (3, 3a) is a dichroic decoupling mirror arranged between the substrate (2, 2a, 2b, 2c, 2d) and the laser medium (1), which is designed to be at least partially transparent for the laser emission (LE) and for the pump radiation (PS), and the dichroic decoupling mirror is partially reflecting for the optical pump radiation (PS) and, together with

      ∘ a second resonator mirror (4),
      ∘ a reflecting boundary surface of the laser medium or
      ∘ total internal reflection in the laser medium (1),
   is constructed and arranged so that
      ∘ resonance for the laser emission (LE) and
      ∘ enhanced intensity for pump radiation (PS) occur, and

   • the substrate (2, 2a, 2b, 2c, 2d, 2e) has a thickness in the direction of laser emission which is, in particular considerably, greater than that of the laser medium (1).

2. Ultrashort pulse microchip laser according to claim 1, **characterized in that** the laser medium (1) is a component reduced in its original material thickness after connection to the substrate (2, 2a, 2b, 2c, 2d, 2e).

3. Ultrashort pulse microchip laser according to claim 2, **characterized in that** the laser medium (1) is a component which is ground and/or polished off after connection to the substrate (2, 2a, 2b, 2c, 2d, 2e).

4. Ultrashort pulse microchip laser according to one of the preceding claims, **characterized in that** a dichroic mirror as a second resonator mirror (4) is arranged between the laser medium (1) and the component designed as a saturable absorber structure for generating a laser emission (LE) with femto- or picosecond pulse characteristics, which is designed to be at least partially transparent for the laser emission (LE) and highly reflective for the pump radiation (PS).

5. Ultrashort pulse microchip laser according to one of the preceding claims, **characterized in that** a resonator element, in particular the saturable absorber structure (5), is arranged on a piezo element (7) .

6. Ultrashort pulse microchip laser according to one of the preceding claims, **characterized by** an entrance window inclined relative to the optical axis of the laser emission (LE) from the laser medium (1).

7. Ultrashort pulse microchip laser according to claim 6, **characterized in that** the inclined entrance window is formed by a wedge-shaped section of the substrate (2b, 2c, 2d) or by an applied wedge-shaped component of diamond (10) or of substrate material.

8. Ultrashort pulse microchip laser according to one of the preceding claims, **characterized in that** on the substrate (2c, 2d) the laser medium and the first resonator mirror are formed in integrated form as a Bragg mirror (8) which is highly reflective for the laser emission (LE) and at least partially transparent for the pump radiation and has grown quantum-well structures (9) as laser medium, wherein the quantum-well structures (9) are arranged in the vicinity of pump radiation isophotes.

9. Ultrashort pulse microchip laser according to one of the preceding claims,
   **characterized in that**
   the component for generating a laser emission (LE) is designed and arranged as a saturable absorber structure (5) in such a way that the ultrashort pulse microchip laser is Q-switched.

10. Laser system having an ultrashort pulse microchip laser according to one of claims 1 to 9,
    **characterized in that**
    the pump radiation (PS) is coupled into the ultrashort pulse microchip laser from the laser medium (1) at a pump radiation incidence angle relative to the optical axis of the laser emission (LE).

11. Laser system according to claim 10,
    **characterized in that**
    the pump radiation incidence angle is chosen so that the distance between pump radiation isophotes corresponds to the half-wave spacing of the laser emission (LE) in the ultrashort pulse microchip laser.

12. Pump method for generating a laser emission (LE) with femto- or picosecond pulses, having at least

    • a substrate (2, 2a, 2b, 2c, 2d, 2e), in particular of vanadate,
    • an amplifying laser medium (1) for generating the laser emission (LE), in particular doped vanadate, preferably Nd:vanadate with a doping of more than 1% Nd,
    • a first resonator mirror (3, 3a, 3b, 3c) at least partially transparent for optical pump radiation (PS),
    • a component for generating a laser emission (LE) with femto- or picosecond pulse characteristics, in particular a saturable absorber structure (5), designed and arranged in such a way that a Q-switching is provided,
    wherein
    the substrate (2, 2a, 2b, 2c, 2d, 2e) and the laser medium (1) are formed from the same material and the substrate (2, 2a, 2b, 2c, 2d, 2e) is doped to a lower level than the laser medium (1), in particular undoped, and the substrate (2,2a, 2b, 2c, 2d, 2e), the laser medium (1) and the first resonator mirror (3, 3a, 3b, 3c), in particular the component for generating a laser emission (LE) with femto- or picosecond pulse characteristics, are connected to each other, and having at least one coupling of optical, in particular pulsed pump radiation (PS), into the laser medium (1), wherein
• the laser medium (1) has a thickness in the direction of laser emission of less than 200 $\mu$m, in particular less than 100 $\mu$m,
• the first resonator mirror (3, 3a) is disposed between the substrate (2, 2a, 2b, 2c, 2d) and the laser medium (1),
• the substrate (2, 2a, 2b, 2c, 2d, 2e) has a thickness in the direction of laser emission which is in particular considerably greater than that of the laser medium (1),
• the first resonator mirror (3, 3a) is a dichroic decoupling mirror arranged between the substrate (2, 2a, 2b, 2c, 2d) and the laser medium (1), which is designed to be at least partially transparent for the laser emission (LE) and for the pump radiation (PS), and the dichroic decoupling mirror is partially reflecting for the optical pump radiation (PS) and, together with

    ○ a second resonator mirror (4),
    ○ a reflecting boundary surface of the laser medium or
    ○ total internal reflection in the laser medium (1)
    is constructed and arranged so that
    ○ resonance for the laser emission (LE) and
    ○ enhanced intensity for pump radiation (PS)
    can be provided, and

• the optical pump radiation (PS) is coupled into the laser medium (1) in such a way that

    ○ the resonance for the laser emission (LE) and
    ○ the enhanced intensity for the pump radiation (PS)
    occur, in particular by selecting the wavelength and incidence angle of the pump radiation (PS) so that pump radiation isophotes correspond to an intensity pattern of the laser emission (LE).

13. Pump method according to claim 12,
    **characterized in that**
    there is a phase shift of zero between pump radiation isophotes and laser emission (LE) at a first resonator mirror (3, 3a, 3b) which is at least partially transparent for the pump radiation (PS).

**Revendications**

1. Laser à micropuce à impulsions ultracourtes à pompage optique pour la génération d'impulsions femto- ou picosecondes, en particulier avec des durées d'impulsion inférieures à 30 ps, inférieures à 10 ps ou inférieures à 1 ps, comprenant au moins

- un substrat (2, 2a, 2b, 2c, 2d, 2e), en particulier en vanadate,
- un milieu laser amplificateur (1) pour générer l'émission laser (LE), en particulier du vanadate dopé, de préférence du Nd:vanadate avec un dopage de plus de 1 % de Nd,
- un premier miroir de résonateur (3, 3a, 3b, 3c) au moins partiellement transparent pour le rayonnement de pompage optique (PS),
- un composant pour générer une émission laser (LE) avec des caractéristiques d'impulsions femto- ou picosecondes, en particulier une structure d'absorbeur saturable (5), réalisé et disposé de telle sorte que le laser à micropuce à impulsions ultra-courtes soit commuté en Q, dans lequel
- le substrat (2, 2a, 2b, 2c, 2d, 2e) et le milieu laser (1) sont constitués du même matériau et le substrat (2, 2a, 2b, 2c, 2d, 2e) est moins dopé que le milieu laser (1), en particulier non dopé, et
- le substrat (2, 2a, 2b, 2c, 2d, 2e), le milieu laser (1) et le premier miroir de résonateur (3, 3a, 3b, 3c), en particulier le composant pour générer une émission laser (LE) avec des caractéristiques d'impulsions femto- ou picosecondes, sont reliés entre eux, dans lequel
- le milieu laser (1) présente une épaisseur dans la direction de l'émission laser inférieure à 200 $\mu$m, en particulier inférieure à 100 $\mu$m,
- le premier miroir de résonateur (3, 3a) est un miroir de découplage dichroïque disposé entre le substrat (2, 2a, 2b, 2c, 2d) et le milieu laser (1), qui est conçu au moins partiellement transparent pour l'émission laser (LE) et pour le rayonnement de pompage (PS), et le miroir de découplage dichroïque est partiellement réfléchissant pour le rayonnement de pompage optique (PS) et est réalisé et disposé avec

  ◦ un deuxième miroir de résonateur (4),
  ◦ une surface limite réfléchissante du milieu laser ou
  ◦ une réflexion interne totale dans le milieu laser (1) de telle sorte qu'il se produit
  ◦ une résonance pour l'émission laser (LE) et
  ◦ une amplification d'intensité pour le rayonnement de pompage (PS),
  et

- le substrat (2, 2a, 2b, 2c, 2d, 2e) présente dans la direction de l'émission laser une épaisseur plus grande, en particulier beaucoup plus grande, que celle du milieu laser (1).

2. Laser à micropuce à impulsions ultracourtes selon la revendication 1, **caractérisé en ce que** le milieu laser (1) est un composant dont l'épaisseur de matériau d'origine est réduite après la liaison au substrat (2, 2a, 2b, 2c, 2d, 2e).

3. Laser à micropuce à impulsions ultracourtes selon la revendication 2, **caractérisé en ce que** le milieu laser (1) est un composant qui est rectifié et/ou poli après la liaison au substrat (2, 2a, 2b, 2c, 2d, 2e) .

4. Laser à micropuce à impulsions ultracourtes selon l'une des revendications précédentes, **caractérisé en ce qu'**un miroir dichroïque servant de deuxième miroir de résonateur (4) est disposé entre le milieu laser (1) et le composant réalisé sous la forme d'une structure d'absorbeur saturable pour générer une émission laser (LE) avec des caractéristiques d'impulsions femto- ou picosecondes, qui est conçu au moins partiellement transparent pour l'émission laser (LE) et hautement réfléchissant pour le rayonnement de pompage (PS).

5. Laser à micropuce à impulsions ultracourtes selon l'une des revendications précédentes, **caractérisé en ce qu'**un élément résonateur, en particulier la structure d'absorbeur saturable (5), est disposé(e) sur un élément piézoélectrique (7).

6. Laser à micropuce à impulsions ultracourtes selon l'une des revendications précédentes, **caractérisé par** une fenêtre d'entrée inclinée par rapport à l'axe optique de l'émission laser (LE) provenant du milieu laser (1).

7. Laser à micropuce à impulsions ultracourtes selon la revendication 6, **caractérisé en ce que** la fenêtre d'entrée inclinée est formée par une partie en forme de coin du substrat (2b, 2c, 2d) ou par un composant en forme de coin rapporté en diamant (10) ou en matériau de substrat.

8. Laser à micropuce à impulsions ultracourtes selon l'une des revendications précédentes, **caractérisé en ce que** le milieu laser et le premier miroir de résonateur sont réalisés sur le substrat (2c, 2d) sous forme intégrée en tant que miroir de Bragg (8) hautement réfléchissant pour l'émission laser (LE) et au moins partiellement transparent pour le rayonnement de pompage, avec des structures à puits quantiques (9) obtenues par croissance en tant que milieu laser, les structures à puits quantiques (9) étant disposées à proximité des isophotes de rayonnement de pompage.

9. Laser à micropuce à impulsions ultracourtes selon l'une des revendications précédentes,
**caractérisé en ce**
**que** le composant pour générer une émission laser (LE) est réalisé et disposé sous la forme d'une structure d'absorbeur saturable (5) de telle sorte que le laser à micropuce à impulsions ultracourtes soit commuté en Q.

10. Système laser avec un laser à micropuce à impulsions ultracourtes selon l'une des revendications 1 à 9,
**caractérisé en ce**
**que** le rayonnement de pompage (PS) est couplé dans le laser à micropuce à impulsions ultracourtes selon un angle d'incidence de rayonnement de pompage par rapport à l'axe optique de l'émission laser (LE) provenant du milieu laser (1).

11. Système laser selon la revendication 10,
**caractérisé en ce**
**que** l'angle d'incidence de rayonnement de pompage est choisi de telle sorte que la distance entre des isophotes de rayonnement de pompage corresponde à la distance d'une demi-longueur d'onde de l'émission laser (LE) dans le laser à micropuce à impulsions ultracourtes.

12. Procédé de pompage pour générer une émission laser (LE) avec des impulsions femto- ou picosecondes, avec au moins

• un substrat (2, 2a, 2b, 2c, 2d, 2e), en particulier en vanadate,
• un milieu laser amplificateur (1) pour générer l'émission laser (LE), en particulier du vanadate dopé, de préférence du Nd:vanadate avec un dopage de plus de 1 % de Nd,
• un premier miroir de résonateur (3, 3a, 3b, 3c) au moins partiellement transparent pour le rayonnement de pompage optique (PS),
• un composant pour générer une émission laser (LE) avec des caractéristiques d'impulsions femto- ou picosecondes, en particulier une structure d'absorbeur saturable (5), réalisé et disposé de telle sorte qu'une commutation Q soit fournie,
dans lequel
le substrat (2, 2a, 2b, 2c, 2d, 2e) et le milieu laser (1) sont constitués du même matériau et le substrat (2, 2a, 2b, 2c, 2d, 2e) est moins dopé que le milieu laser (1), en particulier non dopé, et le substrat (2, 2a, 2b, 2c, 2d, 2e), le milieu laser (1) et le premier miroir de résonateur (3, 3a, 3b, 3c), en particulier le composant pour générer une émission laser (LE) avec des caractéristiques d'impulsions femto- ou picosecondes, sont reliés entre eux et avec au moins un couplage de rayonnement de pompage optique (PS), en particulier pulsé, dans le milieu laser (1),
dans lequel
• le milieu laser (1) présente une épaisseur dans la direction de l'émission laser inférieure à 200 $\mu$m, en particulier inférieure à 100 $\mu$m,
• le premier miroir de résonateur (3, 3a) est disposé entre le substrat (2, 2a, 2b, 2c, 2d) et le milieu laser (1),
• le substrat (2, 2a, 2b, 2c, 2d, 2e) présente dans la direction de l'émission laser une épaisseur plus grande, en particulier beaucoup plus grande, que celle du milieu laser (1),
• le premier miroir de résonateur (3, 3a) est un miroir de découplage dichroïque disposé entre le substrat (2, 2a, 2b, 2c, 2d) et le milieu laser (1), qui est conçu au moins partiellement transparent pour l'émission laser (LE) et pour le rayonnement de pompage (PS), et le miroir de découplage dichroïque est partiellement réfléchissant pour le rayonnement de pompage optique (PS) et est réalisé et disposé avec

○ un deuxième miroir de résonateur (4),
○ une surface limite réfléchissante du milieu laser ou
○ une réflexion interne totale dans le milieu laser (1) de telle sorte qu'une
○ résonance pour l'émission laser (LE) et
○ une amplification d'intensité pour le rayonnement de pompage (PS),

puissent être fournies et
• le rayonnement de pompage optique (PS) est couplé dans le milieu laser (1) de telle sorte que

○ la résonance pour l'émission laser (LE) et
○ l'amplification d'intensité pour le rayonnement de pompage (PS)

se produisent, en particulier en choisissant la longueur d'onde et l'angle d'incidence du rayonnement de pompage (PS) de telle sorte que des isophotes de rayonnement de pompage correspondent à un modèle d'intensité de l'émission laser (LE).

13. Procédé de pompage selon la revendication 12,
**caractérisé en ce**
**qu'**il existe un déphasage de zéro entre les isophotes de rayonnement de pompage et l'émission laser (LE) à un premier miroir de résonateur (3, 3a, 3b) au moins partiellement transparent pour le rayonnement de pompage (PS).

Fig. 1

Fig. 2

Fig. 3

Fig. 4

Fig. 5

Fig. 6

Fig. 7

**Fig. 8**

**Fig. 9**

| Schicht | | Verhältnis x/y | Dicke [nm] | |
|---|---|---|---|---|
| | GaAs | | 75.0 | B |
| | GaAs | | 10.0 | |
| SC | GaAs$_y$P$_{1-y}$ | 0.75 | 7.5 | |
| | GaAs | | 53.5 | |
| QW | In$_x$Ga$_{1-x}$As | ≈ 0.23 | 7.0 | |
| | GaAs | | 63.5 | |
| SC | GaAs$_y$P$_{1-y}$ | 0.75 | 15.0 | |
| | GaAs | | 63.5 | |
| QW | In$_x$Ga$_{1-x}$As | ≈ 0.23 | 7.0 | 9x |
| | GaAs | | 63.5 | |
| SC | GaAs$_y$P$_{1-y}$ | 0.75 | 7.5 | |
| DBR | GaAs | | 75.0 | |
| DBR | AlAs | | 89.2 | 25x |
| | GaAs | | | |

$\mathfrak{Fig}.\ 10$

$\mathfrak{Fig}.\ 11$

Fig. 12

Fig. 13

Fig. 14a

Fig. 14b

Fig. 14c

LE

18

12b

14

17''''

15

12a

11

PS

Fig. 14d

LE

18

12b

14

13

15

12a

11

PS

Fig. 14e

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5343485 A
- US 20050094689 A1

**In der Beschreibung aufgeführte Nicht-Patentliteratur**

- **SPÜHLER G.J. et al.** Experimentally confirmed design guidelines for passively Q switched microchip lasers using semiconductor saturable absorbers. *JOSA B,* Marz 1999, vol. 16 (3
- **BRAUN B. et al.** 56-ps passively Q-switched diode-pumped microchip laser. *Optics Letters,* Marz 1997, vol. 22 (6
- **ZAYHOWSKI J.J. ; WILSON A.L.** Short-pulsed Nd:YAG/Cr4+:YAG passively Q-switched microchip lasers. *OSA/CLEO,* 2003
- **NODOP D. et al.** High-pulse-energy passively Q-switchedquasi-monolithic microchip lasers operating in the sub-100-ps pulse regime. *Optics Letters,* August 2007, vol. 32 (15